(19) Europäisches Patentamt
European Patent Office
Office européen des brevets

(11) **EP 4 513 766 A1**

(12) **EUROPEAN PATENT APPLICATION**
published in accordance with Art. 153(4) EPC

(43) Date of publication:
**26.02.2025 Bulletin 2025/09**

(21) Application number: **23811988.7**

(22) Date of filing: **10.04.2023**

(51) International Patent Classification (IPC):
*H03M 13/11* (2006.01)     *H03M 13/00* (2006.01)

(52) Cooperative Patent Classification (CPC):
**H03M 13/00; H03M 13/11**

(86) International application number:
**PCT/KR2023/004828**

(87) International publication number:
**WO 2023/229211 (30.11.2023 Gazette 2023/48)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **25.05.2022 KR 20220063936**

(71) Applicant: **Samsung Electronics Co., Ltd.**
**Suwon-si, Gyeonggi-do 16677 (KR)**

(72) Inventors:
• **JANG, Min**
  **Suwon-si Gyeonggi-do 16677 (KR)**

• **MYUNG, Seho**
  **Suwon-si Gyeonggi-do 16677 (KR)**
• **KIM, Youngwoo**
  **Suwon-si Gyeonggi-do 16677 (KR)**
• **LEE, Joohyun**
  **Suwon-si Gyeonggi-do 16677 (KR)**
• **LIM, Hyuntack**
  **Suwon-si Gyeonggi-do 16677 (KR)**

(74) Representative: **HGF**
**HGF Limited**
**1 City Walk**
**Leeds LS11 9DX (GB)**

(54) **LAYERED DECODING METHOD AND APPARATUS FOR LOW DENSITY PARITY CHECK CODE IN COMMUNICATION SYSTEM**

(57)     A decoding method performed by a receiver of a communication system, according to an embodiment, comprises the steps of: receiving a signal transmitted from a transmitter; identifying a parity check matrix for decoding the signal; identifying a first layer scheduling sequence corresponding to the parity check matrix; and performing layered decoding on the basis of at least a part of the parity check matrix and at least a part of the first layer scheduling sequence.

FIG. 7

EP 4 513 766 A1

**Description**

**[Technical Field]**

The present disclosure relates to a communication or broadcasting system, and more specifically to a method and an apparatus for decoding data in a communication or broadcasting system.

**[Background Art]**

5G mobile communication technology defines a wide frequency band to enable fast transmission speed and new services, and may be implemented in a frequency band (Sub 6GHz) less than or equal to 6GHz such as 3.5 GHz, as well as ultra-high frequency bands (Above 6GHz) referred to as mmWave such as 28 GHz and 39 GHz. In addition, in a case of 6G mobile communication technology, which is referred to as a system after 5G communication (Beyond 5G), implementation in a Terahertz band (e.g., 95 GHz to 3 Terahertz band) is being considered to achieve a transmission speed 50 times faster and an ultra-low latency reduced to 1/10, compared to 5G mobile communication technology.

In the early days of 5G mobile communication technology, in order to support services for enhanced Mobile Broad Band (eMBB), Ultra-Reliable Low-Latency Communications (URLLC), and massive Machine-Type Communications (mMTC), and satisfy performance requirements, standardization has been processed on Beamforming and Massive MIMO to reduce path loss and increase transmission distance of radio waves in ultra-high frequency bands, supporting for various numerologies (e.g., operation of a plurality of subcarrier intervals) and dynamic operation of slot formats for efficient use of ultra-high frequency resources, an initial access technology to support multi-beam transmission and wideband, definition and operation of Band-Width Part (BWP), a new channel coding method such as a Low Density Parity Check (LDPC) code for large-capacity data transmission and a Polar Code for reliable transmission of control information, L2 pre-processing, and network slicing to provide a dedicated network specialized for a specific service.

Currently, considering services that 5G mobile communication technology is intended to support, discussions are underway for improvement of early 5G mobile communication technology and enhancement performance, physical layer standardization is in progress for technologies on Vehicle-to-Everything (V2X) to help driving determination of autonomous vehicle and increase user convenience based on their location and status information transmitted by the vehicle, New Radio Unlicensed (NR-U) for a system operation satisfying various regulatory requirements in unlicensed bands, NR terminal low power consumption technology (UE Power Saving), Non-Terrestrial Network (NTN), which is a terminal-satellite direct communication to secure coverage in areas where communication with terrestrial networks is impossible, and Positioning.

In addition, standardization of wireless interface architecture/protocol is also in progress for technologies on Industrial Internet of Things (IIoT) for supporting a new service through linkage and convergence with other industries, Integrated Access and Backhaul (IAB) providing a node for expanding network service areas by integrating and supporting wireless backhaul link and access link, Mobility Enhancement including Conditional Handover and Dual Active Protocol Stack (DAPS) handover, and 2-step RACH for NR simplifying random access procedures, and standardization of system architecture/service field is also in progress for technologies on 5G baseline architecture (e.g., Service based Architecture, Service based Interface) for grafting Network Functions Virtualization (NFV) and Software-Defined Networking (SDN), and Mobile Edge Computing (MEC) that are provided with services based on a location of a terminal.

If these 5G mobile communication system is commercialized, connected devices, which are growing explosively, will be connected to the communication network, so it is expected that enhancement of functions and performance of the 5G mobile communication system and integrated operation of connected devices will be required. To this end, new research will be conducted on extended Reality (XR) to efficiently support Augmented Reality (AR), Virtual Reality (VR), and Mixed Reality (MR), improving 5G performance and reducing complexity using Artificial Intelligence (AI) and Machine Learning (ML), AI service support, metaverse service support, and drone communication.

In addition, the development of these 5G mobile communication systems could be the basis for the development of technologies of a multiple antenna transmission technology such as a new waveform to ensure a coverage in the terahertz band of 6G mobile communication technology, Full Dimensional MIMO (FD-MIMO), Array Antenna, and Large Scale Antenna, Metamaterial-based lens and antenna to improve a coverage of terahertz band signals, high-dimensional spatial multiplexing technology using Orbital Angular Momentum (OAM), and Reconfigurable Intelligent Surface (RIS), as well as Full duplex technology to enhance frequency efficiency of 6G mobile communication technology and improve a system network, AI-based communication technology that utilizes satellite and Artificial Intelligence (AI) from a design stage and implements end-to-end AI support functions to realize system optimization, and next-generation distributed computing technology that realizes services with complexity exceeding the limits of terminal computing capabilities by utilizing ultra-high-performance communication and computing resources.

In general, in a case that data is transmitted and received between a transmitter and a receiver in a communication and broadcasting system, performance of a link may be significantly degraded by various types of noise, fading phenomena, and inter-symbol interference (ISI) present in a communication channel. Therefore, in order to implement a high-speed digital communication or broadcasting system requiring high data throughput and reliability, such as next-generation mobile communication, digital broadcasting, and mobile Internet, developing a technology for overcoming noise, fading, and inter-symbol interference is required. Error detection codes and error correcting codes (ECC) methods are used to overcome errors capable of being caused by communication channels, in the receiver. In particular, error correcting codes used in communication between transceivers are generally referred to as channel coding or forward error correction (FEC). The transmitter encodes a data bit sequence to be transmitted to generate and transmit a codeword bit sequence of longer length, and the receiver decodes a codeword bit sequence mixed with error or noise to overcome error/noise and estimate a data bit sequence.

Various channel coding techniques are used in a communication and broadcasting system. Channel coding techniques used today include convolutional code, turbo code, low-density parity-check coding (LDPC code), and polar code. As a length of a code increases, the LDPC code among these channel coding techniques shows superior error correcting performance compared to other channel coding techniques. Additionally, since the LDPC code has a code structure suitable for parallelization and a belief-propagation (BP) decoding operation accordingly, the LDPC code is very suitable for use in an application system requiring high-throughput. Because of these advantages, the LDPC codes are used in various communication and broadcasting systems such as IEEE 802.11n/ad Wi-Fi, DVB-T2/C2/S2, ATSC 3.0, and in particular, they have recently been adopted and used in 3GPP New Radio (NR) system, which is a 5G mobile communication system. The present specification relates to accurately estimating transmitted information by effectively decoding a signal encoded in the LDPC codes.

**[Disclosure]**

**[Technical Problem]**

The present specification provides a device and a method for efficiently decoding a low-density parity-check (LDPC) code in a communication or broadcasting system. In addition, the present specification provides a method and a device for decoding LDPC codes to improve decoding performance while reducing decoding complexity by applying appropriate layer scheduling according to structural, algebraic, and analytical characteristics of the LDPC code when decoding the LDPC codes using sub-sequential layered scheduling or a similar method.

**[Technical Solution]**

According to an embodiment of the present disclosure for solving the above problem, a decoding method performed by a receiver of a communication system may comprise receiving a signal transmitted from a transmitter, identifying a parity check matrix for decoding the signal, identifying a first layer scheduling sequence corresponding to the parity check matrix, and performing layered decoding based on at least a portion of the parity check matrix and at least a portion of the first layer scheduling sequence, wherein each index included in the first layer scheduling sequence may correspond to a row block of the parity check matrix, wherein the first layer scheduling sequence may correspond to a plurality of layers of which each layer is configured with one or more row block of the parity check matrix, wherein the plurality of layers corresponding to the first layer scheduling sequence may respectively correspond to one or more index included in the first layer scheduling sequence, and wherein at least one layer among the plurality of layers corresponding to the first layer scheduling sequence may be configured with a plurality of orthogonal row blocks in the parity check matrix.

In addition, according to an embodiment of the present disclosure, a receiver performing decoding in a communication system may comprise a transceiver, and a control unit configured to receive a signal transmitted from a transmitter, identify a parity check matrix for decoding the signal, identify a first layer scheduling sequence corresponding to the parity check matrix, and perform layered decoding based on at least a portion of the parity check matrix and at least a portion of the first layer scheduling sequence, wherein each index included in the first layer scheduling sequence may correspond to a row block of the parity check matrix, wherein the first layer scheduling sequence may correspond to a plurality of layers of which each layer is configured with one or more row block of the parity check matrix, wherein the plurality of layers corresponding to the first layer scheduling sequence may respectively correspond to one or more index included in the first layer scheduling sequence, and wherein at least one layer among the plurality of layers corresponding to the first layer scheduling sequence may be configured with a plurality of orthogonal row blocks in the parity check matrix.

**[Advantageous Effects]**

A device and a method according to various embodiments of the present disclosure can support efficient decoding performance and convergence speed according to decoding scheduling of LDPC code.

A device and a method according to various embodiments of the present disclosure can enhance decoding performance, that is, improved error-correction performance and fast decoding convergence performance, through a decoding method of LDPC code based on layered scheduling.

The effects that can be obtained from the present disclosure are not limited to those described above, and any other effects not mentioned herein will be clearly understood by those having ordinary knowledge in the art to which the present disclosure belongs, from the following description.

[Description of the Drawings]

FIG. 1 is a diagram illustrating a wireless communication system according to various embodiments of the present disclosure.

FIG. 2 is a diagram illustrating an example of a configuration of a device for performing communication in a wireless communication system according to various embodiments of the present disclosure.

FIG. 3 is a diagram illustrating an embodiment of a parity check matrix of an LDPC code.

FIG. 4 is a diagram illustrating a binary graph corresponding to the parity check matrix of FIG. 3.

FIG. 5 is a diagram illustrating a configuration of a transmission device according to an embodiment of the present disclosure.

FIG. 6 is a diagram illustrating a configuration of a reception device according to an embodiment of the present disclosure.

FIG. 7 is a diagram illustrating an example of a parity check matrix according to an embodiment of the present disclosure.

FIG. 8 is a diagram illustrating an example of a parity check matrix configured with a plurality of submatrix according to an embodiment of the present disclosure.

FIG. 9 is a diagram illustrating an example of a sub parity-check matrix according to an embodiment of the present disclosure.

FIG. 10 is a diagram illustrating another example of a sub parity-check matrix according to an embodiment of the present disclosure.

FIG. 11 is a diagram illustrating an example of a parity check matrix defined based on BG2 in a 3GPP NR LDPC code system.

FIG. 12 is a diagram illustrating a deformed parity check matrix in which the parity check matrix defined based on BG2 of FIG. 11 is mixed in an order of a scheduling sequence according to an embodiment of the present disclosure.

FIG. 13 is a diagram respectively illustrating block error rates of layered decoding in a natural order and layered decoding that is layer scheduled by an embodiment of the present disclosure, with respect to a parity check matrix defined based on BG1.

FIG. 14 is a diagram respectively illustrating block error rates of layered decoding in a natural order and layered decoding that is layer scheduled by an embodiment of the present disclosure, with respect to a parity check matrix defined based on BG2.

[Mode for Invention]

Hereinafter, an embodiment of the present disclosure will be described in detail with accompanying drawings.

In describing an embodiment, description of technical content well known in the technical field to which the present disclosure belongs and not directly related to the present disclosure is omitted. This is to convey the gist of the present disclosure more clearly without blurring by omitting unnecessary explanations.

For the same reason, some components are emphasized, omitted, or schematically illustrated in the accompanying drawings. In addition, a size of each component does not entirely reflect an actual size. In each drawing, the same reference numbers are assigned to identical or corresponding components.

Advantages and features of the present specification and methods for achieving them will become apparent with reference to embodiments described below in detail together with the accompanying drawings. However, the present specification is not limited to the embodiments disclosed below, and may be implemented in various different forms, and the present embodiments are provided merely to make the disclosure of this specification complete and to fully inform those having ordinary knowledge in the art to which the present specification belongs the scope of the specification, and the specification is only defined by the scope of the claims. Throughout the specification, identical reference numerals refer to identical components.

In this case, it will be understood that each block of the processing flowchart drawings and combinations of the flowchart drawings may be performed by computer program instructions. Since these computer program instructions may be mounted on a processor of a general-purpose computer, a special-purpose computer, or other programmable data processing device, the instructions performed through a processor of a computer or other programmable data processing device generate means for performing functions described in the flowchart block(s). Since these computer program instructions may be stored in computer-available or computer-readable memory that may be directed to a computer or other programmable data processing device to implement functions in a specific way, instructions stored in the computer-available or computer-readable memory may produce a manufacturing item including instruction means performing the functions described in the flowchart block(s). Since computer program instructions may be mounted on a computer or other programmable data processing device, instructions performed by a computer or other programmable data processing device may provide steps for executing the functions described in the flowchart block(s) by performing a series of operational steps on the computer or the other programmable data processing device and generating a process executed by a computer.

In addition, each block may indicate a module, a segment, or a part of a code including one or more executable instructions for executing a specified logical function(s). In addition, it should be noted that the functions mentioned in the blocks may occur out of order in some alternative execution examples. For example, consecutively shown two blocks may be executed substantially simultaneously, or the blocks may sometimes be executed in reverse order, according to corresponding functions.

In this case, the term '-unit' used in the present embodiment refers to a software or a hardware component such as FPGA or ASIC, and '-unit' performs certain roles. However, '-unit' is not limited to software or hardware. The '-unit' may be configured to be in an addressable storage medium or may be configured to reproduce one or more processors. Therefore, as an example, '-unit' includes components such as software components, object-oriented software components, class components, and task components, and processes, functions, attributes, procedures, subroutines, segments of program code, drivers, firmware, microcode, circuitry, data, databases, data structures, tables, arrays, and variables. Functions provided within the components and '-unit' may be combined into a smaller number of components and '-unit', or further separated into additional components and '-unit'. In addition, components and '-unit' may be implemented to reproduce one or more CPUs in a device or secure multimedia card.

Hereinafter, various embodiments will be described in detail with reference to the accompanying drawings. In this case, it should be noted that identical elements are indicated by identical reference numerals in the accompanying drawing where possible. In addition, the drawings of the present specification attached below are provided to help understanding of the present specification, and it should be noted that the present specification is not limited to the shape or arrangement exemplified in the drawings of the present specification. Furthermore, detailed descriptions of functions and configurations that may obscure the gist of the present specification will be omitted. It should be noted that only parts required to understand operations according to various embodiments of the present specification are described in the following description, and other descriptions will be omitted so as not to disperse the gist of the present specification.

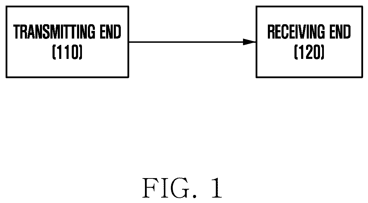

FIG. 1 is a diagram illustrating a wireless communication system according to various embodiments of the present disclosure. Referring to FIG. 1, a wireless communication system according to an embodiment of the present disclosure is a device or a node using a wireless channel and may include a transmitting end 110 and a receiving end 120. FIG. 1 illustrates one transmitting end 110 and one receiving end 120, but a plurality of transmitting ends or a plurality of receiving ends may be included. In addition, for convenience of explanation in this disclosure, it is explained that the transmitting end 110 and the receiving end 120 are separate entities, but functions of the transmitting end 110 and the receiving end 120 may be interchanged. For example, in a case of uplink in a cellular communication system, the transmitting end 110 may be a terminal and the receiving end 120 may be a base station. In a case of downlink, the transmitting end 110 may be a base station and the receiving end 120 may be a terminal.

In various embodiments, the transmitting end 110 may generate a codeword by encoding information bits based on an LDPC code, and the receiving end 120 may decode a signal of received codeword based on the LDPC code. For example, the receiving end 120 may use an LDPC decoding method according to this specification and may perform a syndrome check to determine whether the decoding result is normal. The transmitting end 110 and the receiving end 120 perform LDPC encoding and decoding using a parity check matrix known to each other. For example, the parity check matrix may include a parity check matrix defined in 3GPP NR standard.

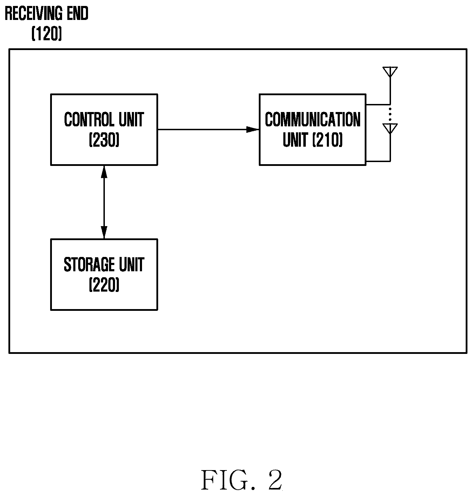

FIG. 2 is a diagram illustrating an example of a configuration of a device for performing communication in a wireless communication system according to various embodiments of the present disclosure. That is, a configuration exemplified in FIG. 2 may be understood as a configuration of the receiving end 120. Hereinafter, the terms '...unit' and '...er' used refer to a unit processing at least one function or operation, which may be implemented by a hardware or a software, or a combination of hardware and software.

Referring to FIG. 2, a device may include a communication unit 210, a storage unit 220, and a control unit 230.

The communication unit 210 may perform functions for transmitting and receiving a signal through a wireless channel. For example, the communication unit 210 may perform a conversion function between a baseband signal and a bit string according to a physical layer standard of a system. For example, when transmitting data, the communication unit 210 may generate complex symbols by encoding and modulating a transmission bit string. In addition, when receiving data, the communication unit 210 may restore the received bit string by demodulating and decoding the baseband signal.

In addition, the communication unit 210 may upconvert the baseband signal into a radio frequency (RF) band signal, transmit it through an antenna, and down-convert a RF band signal received through an antenna into a baseband signal.

To this end, the communication unit 210 may include a transmission filter, a reception filter, an amplifier, a mixer, an oscillator, a digital to analog converter (DAC), an analog to digital converter (ADC), and the like. In addition, the communication unit 210 may include a plurality of transmission/reception paths. Furthermore, the communication unit 210 may include at least one antenna array configured with a plurality of antenna elements. In terms of hardware, the communication unit 210 may be configured with a digital unit and an analog unit, and the analog unit may be configured with a plurality of sub-units according to operating power, operating frequency, and the like. In addition, the communication unit 210 may include a decoding unit to perform decoding according to various embodiments of the present disclosure.

The communication unit 210 transmits and receives a signal as described above. Accordingly, the communication unit 210 may be referred to as a 'transmission unit', a 'reception unit', or a 'transceiver'. In addition, in the following description, transmission and reception performed through a wireless channel are also used to mean that the processing described above is performed by the communication unit 210. In addition, when the device of FIG. 2 is a base station, the communication unit 210 may further include a backhaul communication unit for communication with another network object connected through a backhaul network.

The storage unit 220 may store data such as a basic program for an operation of the receiving end 120, an application program, and setting information. The storage unit 220 may be configured with a volatile memory, a nonvolatile memory, or a combination of the volatile memory and the nonvolatile memory. In addition, the storage unit 220 may provide stored data according to a request of the control unit 230.

The control unit 230 may control overall operations of the device. For example, the control unit 230 may transmit and receive a signal through the communication unit 220. In addition, the control unit 230 may record or read data in the storage unit 230. To this end, the control unit 230 may include at least one processor or micro-processor, or may be a part of the processor. According to various embodiments, the control unit 230 may control the device to perform operations according to various embodiments described below.

This disclosure describes various embodiments using terms used in some communication standards (e.g., 3rd Generation Partnership Project (3GPP)), but it is only an example for explanation. Various embodiments of the present disclosure may be easily modified and applied in other communication systems.

In addition, in the process of explaining this specification in detail, commonly used mathematical symbols are used to avoid ambiguity in meaning. Such mathematical symbols may be clearly understood by those of ordinary skill in the technical field to which the present disclosure belongs. Representatively, the following mathematical symbols are used in the present disclosure.

- Calligraphic characters (e.g., $\mathcal{A}$) are used to indicate sets.
- Unless otherwise stated throughout this disclosure, it is assumed that an index of a first element of a set, a sequence, or a vector starts from 0 (zero-based numbering).
- For a set of indexed elements $\mathcal{A} = \bigcup_{k \in \mathcal{K}} \{a_k\}$, $\langle \mathcal{A} \rangle$ indicates a set $\mathcal{K}$ of indexes of elements. For example, for $\mathcal{A} = \{a_3, a_4, a_7, a_8\}$, it is $\langle \mathcal{A} \rangle = \{3, 4, 7, 8\}$.
- For two sets $\mathcal{A}$ and $\mathcal{B}$, $\mathcal{A} \backslash \mathcal{B}$ indicates a relative complement of set $\mathcal{B}$ to set $\mathcal{A}$.
- For the set $\mathcal{A}$ and an arbitrary number $b$, $b + \mathcal{A}$ indicates a set $\{a + b \mid a \in \mathcal{A}\}$ configured with values obtained by adding $b$ to all elements of $\mathcal{A}$.
- Symbols $\mathbb{N}$, $\mathbb{Z}$, and $\mathbb{R}$ are used to indicate a set of natural numbers, a set of integers, and a set of real numbers, respectively.
- For non-negative integer $n$, $\mathbb{Z}_n$ indicates a set of $n$ consecutive integers from 0 to $n - 1$. That is, it is

$$\mathbb{Z}_n = \{0, 1, ..., n - 1\}$$

- Boldface lowercase letters (e.g., a) are used to indicate vectors, and boldface uppercase letters (e.g., A) are used to indicate matrixes. In a case of a vector, unless otherwise stated, it indicate a column vector.
- For vector a and matrix T, $\mathbf{a}^T$ and $\mathbf{A}^T$ indicate respective transposes.
- For matrix A and two nonnegative integers ' and $j$, $(\mathbf{A})_{i,j}$ indicates an element in - th row, $j$-th column of matrix A.
- For matrix A and two nonnegative integer sets $\mathcal{R}$ and $\mathcal{C}$, $(\mathbf{A})_{\mathcal{R} \times \mathcal{C}}$ indicates a submatrix configured with rows specified by elements of set $\mathcal{R}$ and columns specified by elements of set $C$ in the matrix A.

A low-density parity-check (LDPC) code is an error-correction code having performance close to the channel capacity. An iterative belief-propagation decoding algorithm for the LDPC code is suitable for implementation in a parallel architecture, making it easy to achieve high decoding throughput. Due to these excellent performance and implementation-friendly characteristics, the LDPC code is used in various communication and broadcasting systems. In particular, it has been recently adopted and used in the 5th Generation (5G) New Radio (NR) mobile communication system standard of 3GPP.

The LDPC code, which is a linear code, is defined by a parity-check matrix. The number of information bits (also called code dimension) to be encoded using the LDPC code is written as $H$, and the number of codeword bits (code length) that are the encoded result is written as $N$. A code rate is defined as $R = K/N$, and a value $M = N - K$, which is the code length minus the code dimension, is called the number of parity bits and the number of redundant bits. Encoding input information bit sequence of a length H may be a codeword sequence encoded by an outer coding such as a cyclic redundancy check (CRC) code. In addition, encoding input information bit sequence of length $K$ may include a shortening bit (also called a filler bit). This shortening bit is a bit, which is added to fit a code structure as the number of input information bits is smaller than fixed code dimension $K$ of the LDPC code, usually has a value of 0 and is used in encoding, but is excluded from the final transmission. Since the receiver knows a bit value even though corresponding value is not transmitted, decoding is performed using such information. This shortening is a type of code modification or rate matching.

When $\mathbb{F}_2 = \{0, 1\}$ is called a binary field, a codeword bit vector of length $N$ is represented as $\mathbf{x} = (x_0, x_1, \ldots, x_{N-1}) \in \mathbb{F}_2^N$. When a parity check matrix is given as $H \in \mathbb{F}_2^{M \times N}$, all valid codeword bit vectors are generated so as to satisfy a relationship of Equation 1 below.

[Equation 1]

$$\mathbf{H}\mathbf{x} = \mathbf{0}$$

In the Equation 1, $\mathbf{0} \in \mathbb{F}_2^M$ is a zero vector of length $M$. According to Equation 1, an arbitrary codeword bit vector $\mathbf{X}$ of an LDPC code defined by a parity check matrix H is a nullspace for the parity check matrix H. Herein, a row vector corresponding to $j$-th row of H is denoted as $\mathbf{h}_j \in \mathbb{F}_2^{1 \times N}$, and an element of the $j$-th row, -th column of H is denoted as $h_{ji} \in \mathbb{F}_2$. Encoding and decoding of LDPC codes are based on this parity check matrix H.

Now, a general decoding process of LDPC codes defined by the parity check matrix H is described in detail using a diagram. The decoding of LDPC codes may be understood as a so-called belief-propagation (BP) process, which repeatedly exchanges messages on a bipartite graph corresponding to the parity check matrix.

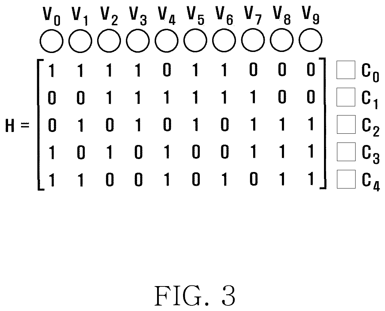

FIG. 3 is a diagram illustrating an embodiment of a parity check matrix of an LDPC code. Specifically, FIG. 3 illustrates an example of a parity check matrix $H \in \mathbb{F}_2^{5 \times 10}$ of a binary LDPC code where the number of rows is $M = N - K = 5$ and the number of columns is $N = 10$. The number of 1 in a parity check matrix is called density, and this density determines complexity of encoding and decoding. The density of a normal parity check matrix of an LDPC code is very low compared to a total size of the parity check matrix, so it is called a low-density parity check code. It should be noted that the parity check matrix in FIG. 3 is a very small matrix as an example for explanation so its density is relatively high, and the density of a parity check matrix with a larger dimension generally used may be much lower.

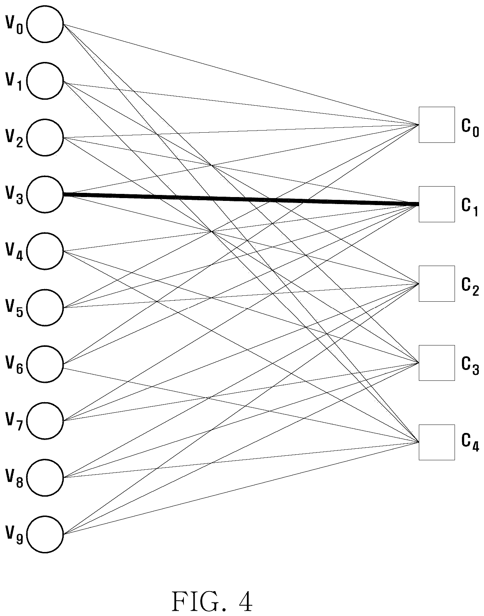

FIG. 4 is a diagram illustrating a binary graph corresponding to the parity check matrix of FIG. 3. A binary graph shown in FIG. 4 may be configured with a set $V (|V| = N)$ of variable nodes, a set $\mathcal{C} (|\mathcal{C}| = N - K)$ of check nodes, and a set $\varepsilon$ of edges connecting elements of the two sets. The variable nodes correspond to each bit of the codeword bit vector $\mathbf{x} \in \mathbb{F}_2^N$, and -th variable node indicates ' -th codeword bit $x_i$ with the same index. The check node indicates a linear equation indicated by an inner product of each row of the parity check matrix H and the binary field of the codeword bit vector X. That is, $j$-th check node indicates a linear equation corresponding to $\mathbf{h}_j \mathbf{x} = \sum_{i=0}^{N-1} h_{ji} x_i = 0$, and indicates that a result of performing a binary sum (modulo-2 sum, bitwise XOR) of the bit values of all variable nodes connected to $j$-th check node on a binary graph given by H is 0. The belief-propagation decoding of LDPC codes may be understood as an iterative message exchange process using a relationship between variable nodes and check nodes on such graphs.

The LDPC code is used in various communication and broadcasting systems because it has excellent performance and is advantageous in achieving high throughput, and is designed and used to meet a requirement given according to a characteristic of the system.

For example, one of the required characteristics of a channel code for communication systems is flexible adjustment of a code length (length-flexibility). In a communication system, the number of information bits to be transmitted may be changed at each transmission. In addition, in a communication system, the amount of communication resource, such as time and frequency available for transmission of specific information may be changed at each transmission according to various reasons. For example, the amount of the total available communication resources may be changed, or the amount of communication resources allocated to transmit corresponding information from the total available communication resources may be changed. Since the number of bits capable of transmitting is changed at each transmission moment, a channel code used for a communication system should be designed to flexibly process encoding and decoding in a situation where the number of input bits and the number of output bits of encoding is variably changed.

Another required characteristic of a channel code for communication system is rate-flexibility. In a communication system, especially a mobile communication system, a channel quality between a transmitter and a receiver is changed constantly. For example, when the receiver moves physically, a distance between the transmitter and the receiver may be changed, and thus a channel environment such as path loss and multi-path fading may be different. When a channel quality is good, the transmitter may achieve encoding or decoding without error, by increasing a code rate (i.e., reducing the number of parity bits) and efficiently utilizing communication resources. On the other hand, when the channel quality is poor, the transmitter may increase a probability of overcoming the poor channel, by decreasing the code rate (i.e., increasing the number of parity bits). Therefore, a channel code used in a communication system should be designed to flexibly change a code rate according to a situation.

The LDPC codes for a practical communication system are designed to have the above-described required characteristics (length-flexibility, rate-flexibility). Representatively, the LDPC codes satisfying the above-described required characteristics are designed and used in 3GPP NR mobile communication system.

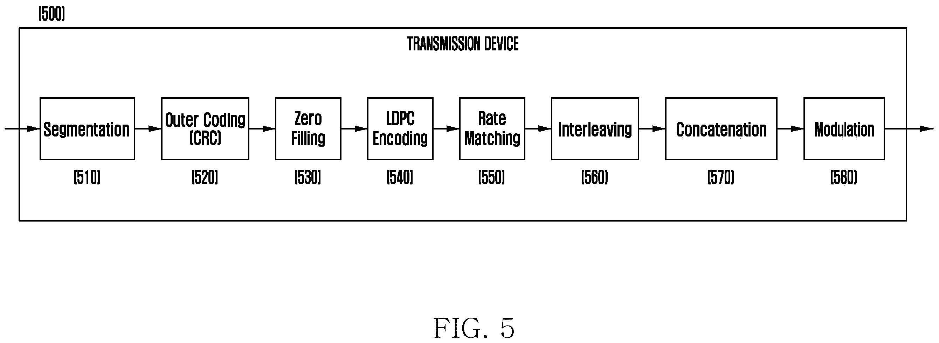

FIG. 5 is a diagram illustrating a configuration of a transmission device according to an embodiment of the present disclosure.

Referring to FIG. 5, in order to transmit an input bit sequence by LDPC encoding and modulating, a transmission device 500 may include a segmentation unit 510, an external encoding unit 520, a zero-padding unit 530, an LDPC encoding unit 540, a coding rate matching unit 550, an interleaving unit 560, a coupling unit 570, a modulation unit 580, and the like. Any of following modulation methods are possible, for example, binary phase shift keying (BPSK), $\pi/2$-BPSK, quadrature phase shift keying (QPSK), quadrature amplitude modulation (16-QAM), 64-QAM, 256-QAM, 1024QAM, and the like. The components illustrated in FIG. 5 above are components performing encoding and modulation for an input bit sequence, and it is only an example, and in some cases, some of the components illustrated in FIG. 5 may be omitted or changed, and another component may be added.

For encoding and modulation, the transmission device 500 determines code parameters to be used for the LDPC code, based on given scheduling parameters such as the number of input bits, the number of final output bits, and the code rate, which is a relationship therebetween. The code parameters may include a parity check matrix of the LDPC code to be used and information thereof, information for segmentation, information for code rate adjustment (shortening, perforation, repetition, and the like), information for bit interleaving, information for modulation, and the like.

Information bits to be transmitted by the transmission device 500 are referred to as a transport block (TB). These transport blocks may be a result of being encoded in advance by an external code such as a cyclic redundancy check (CRC) code.

Since a size of the transport block (the number of bits of the transport block) is variable, when a length of the inputted block is greater than the number of input bits capable of being encoded with the determined parity check matrix, the segmentation unit 510 may divide, that is segmentation, the transport block into several code blocks (CB), so that a length of the transport block is less than or equal to a preset value. Each of segmented code blocks corresponds to an input to one LDPC encoding unit. When the number of input bits is less than or equal to a preset value, segmentation is not performed. The number of code blocks determined or calculated through the above process is called $C$, and a size (the number of entire bits in the code block) of $r$-th code block is written as $A_r$ ($r = 0, ..., C - 1$).

The external encoding unit 520 may externally encode each segmented code block. Examples of external coding include cyclic redundancy check (CRC) coding and are not limited to special coding techniques. A length of the externally encoded r-th code block is written as $B_r$, and has a $B_r \geq A_r$ relationship. When external encoding is not performed, $B_r = A_r$. A bit sequence generated in this way is inputted to the LDPC encoding unit, and therefore is referred to as an encoder input bit sequence.

The encoder input bit sequence for the code block is respectively LDPC encoded independently, and all are processed in the same process. Therefore, when understanding how one code block is encoded, the entire processing process of the transmission device is sufficiently understood. Accordingly, the LDPC encoding process for one code block will be described below. For simplicity of expression, a subscript r indicating an index of the code block is dropped.

The externally encoded encoder input bit sequence with the length $B$ may be smaller than a determined size of the LDPC code used, specifically, a code dimension $K$ of the parity check matrix used. In this case, $F = K - B$ filler bits may be added to the inputted code block. Filler bits may be added to the encoder input bit sequence in various ways, and an appending method of adding $F$ filler bits after the encoder input bit sequence is generally used. This method of adding filler bits is not limited to a specific way. In addition, the filler bits may be determined to any value, but are generally determined to have a bit value of 0. For this reason, this process is also referred to as zero filling, zero padding, and the like, and may be performed by the zero padding unit 530 of the transmitter. Since these filler bits have no value as actual information, they may be excluded from the final transmission. The filler bits may be understood as a shortening process, which is one of code modification methods that reduces a code length and code dimension by the same amount.

As described above, if necessary, the LDPC encoding unit 540 may perform LDPC encoding after adjusting an input length of the LDPC encoding to $K$. The LDPC encoding is performed based on a parity check matrix $\mathbf{H} \in \mathbb{F}_2^{M \times N}$ determined by the scheduling parameter, code parameter, and the like. Specifically, the LDPC encoding is a process of generating a mother codeword $\mathbf{x} \in \mathbb{F}_2^N$ with length $N$ that satisfies Equation 1 based on the bit sequence for a code block given through the above series of processes. If the bit sequence of the inputted code block is directly indicated in the mother codeword bit sequence, it is called a systematic code, and if not, it is called a non-systematic code.

A mother codeword x of length $N$ is generated by an output of the LDPC encoding, and the code rate matching unit 550 may transform the generated mother codeword to suit a transmission environment and transmission resources through a rate matching process. A length of a coded bit sequence to be finally transmitted for the corresponding code block is referred to as a rate matching size $E$, which is a parameter determined by scheduling, such as the transmission environment and transmission resources. As in the other symbols, a rate matching size of the $r$-th code block is written as $r$, which deals with an encoding sequence of a code block, so it should be noted that it is written as $E$ except for a subscript $r$ for simplicity of expression. The rate matching process may be understood as a process of generating an encoder output bit sequence of a length E from a mother codeword $\mathbf{X}$ of length $N$.

The rate matching process may be implemented in various ways, for example, it may be systematically performed through a simple rule using a circular buffer. A size of the circular buffer to be used is referred to as $N_{CB}$, and the $N_{CB}$ may be different from a length $N$ of the mother codeword. Usually, $N_{cb}$ is determined to be a value less than or equal to $N$. As an example, in the 3GPP NR LDPC encoding system, in case that there are no special restrictions, the $N_{CB}$ is determined to be $N - 2Z$ ($Z$, which is a lifting size described later, is a positive integer between 2 and 384). If a circular buffer of $N_{CB}$ length is D = ($d_0, d_0, \dots, d_{Ncb-1}$), each bit of the circular buffer is determined to be a bit of the mother codeword x = ($x_0, x_1, \dots, x_{N-1}$), as shown in Equation 2 below.

$$\text{【Equation 2】}$$

$$d_i = x_{2Z+i}, \qquad i = 0, 1, \dots, N_{cb} - 1$$

When configuring a circular buffer D as shown in Equation 2 above, a first $2Z$ bits of mother codeword X are not stored or recorded in the circular buffer, and are therefore excluded from transmission. 3GPP NR LDPC code is a systematic code, and an encoder input bit sequence (i.e., information bit sequence) is directly indicated in the first $K$ bits, in a mother codeword of length $N$. Therefore, in the 3GPP NR LDPC encoding system, systematic puncturing or information puncturing in which **2Z** bits among the information bits are fixedly punctured occurs. Instead of less information bits being transmitted in this way, more parity bits generated during the encoding process are transmitted.

The rate matching unit 550 selects $E$ bits, by reading the circular buffer D configured as above sequentially (in the same way as $d_s, d_{s+1}, d_{s+2}, \dots$) and circularly (moving to $d_{Ncb-1}$ that is a first point of a buffer when reaching $d_{Ncb-1}$ that is the end of the buffer) from a predetermined starting point $S$. The point $S$ where the circular buffer starts reading may be determined by considering using Hybrid Automatic Repeat reQuest (HARQ). Additionally, when selecting $E$ bits from the circular buffer, $F$ filler bits added in the zero-padding process of the zero padding unit 530 are not selected. If the rate matching bit is $E < N_{cb}$, puncturing in which $N_{cb} - E$ codeword bits among the codeword bits recorded in the circular buffer are excluded from transmission occurs. If $E > N$. a repetition in which all or part of codeword bits among the codeword bits recorded in the circular buffer are transmitted more than twice occurs.

A bit sequence of length $E$ generated by the rate matching may be transmitted through a bit interleaved coded modulation (BICM) technique, and in this case, the interleaving unit 560 may perform interleaving on the rate matched bit sequence for appropriately mapping bits to modulation symbols.

In case that the transport block is segmented into two or more code blocks, the coupling unit 570 may perform concatenation to collect the series of encoding process outputs for each code block into one (570). Herein, each of results of the code block may be simply concatenated sequentially, or may be mixed and concatenated according to a predetermined pattern.

After all operations in bit unit are performed, the modulation unit 580 may generate a baseband signal to be transmitted through modulation. In the modulation process, various additional operations may be performed for a reception device to effectively demodulate and restore a signal, which will be described later. The baseband signal may be transmitted on a carrier of a band to be used for transmission. Through the series of operations, the bits of the transport block are transmitted via encoding and modulation.

Meanwhile, FIG. 5 describes functional configurations for LDPC encoding, but in some cases, the transmission device 500 may further include configurations for controlling the operation of the transmission device.

According to an embodiment, the transmission device 500 may further include a communication unit. The communication unit performs functions for transmitting and receiving a signal through a wireless channel. For example, the communication unit performs a conversion function between a baseband signal and a bit according to a physical layer specification of a system. For example, when transmitting data, the communication unit generates a complex symbol by encoding and modulating a transmission bit string. In addition, when receiving data, the communication unit restores a reception bit string by demodulating and decoding a baseband signal. In addition, the communication unit up-converts a baseband signal into a radio frequency (RF) band signal and transmits it through an antenna, and down-converts a RF band signal received through an antenna into a baseband signal. According to various embodiments, the transmission device 500 may transmit a LDPC encoded signal to a reception device 600 to be described later.

To this end, the communication unit may include a transmission filter, a reception filter, an amplifier, a mixer, an oscillator, a digital-to-analog converter (DAC), and an analog-to-digital converter (ADC). In addition, the communication unit may include a plurality of transmission and reception paths. Furthermore, the communication unit may include at least one antenna array configured with a plurality of antenna elements. In terms of hardware, the communication unit may be configured with a digital unit and an analog unit, and the analog unit may be configured with a plurality of sub-units according to operating power, operating frequency, and the like.

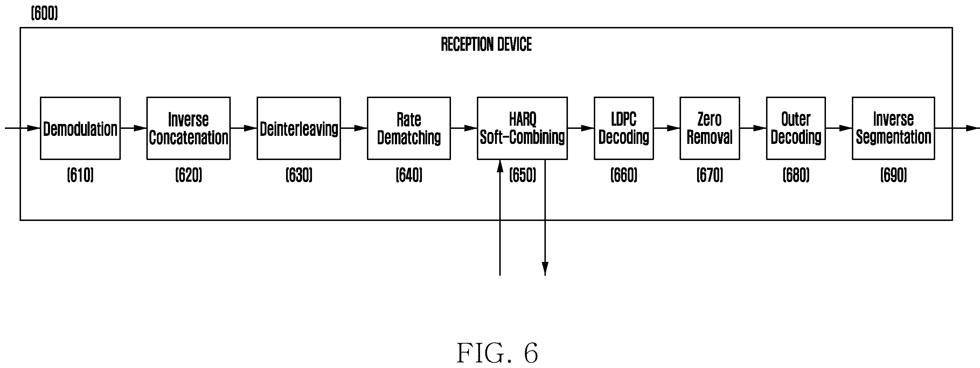

FIG. 6 is a diagram illustrating a configuration of a reception device according to an embodiment of the present disclosure. Referring to FIG. 6, in order to estimate an accurate information bit from a received signal, a receiving device 600 may include a demodulation unit 610, an inverse-coupling unit 620, a deinterleaving unit 630, a rate dematching unit 640, a soft combining unit 650, an LDPC decoding unit 660, a zero-removal unit 670, an external decoding unit 680, and an inverse-segmentation unit 690.

Like the transmission device 500, the reception device 600 identifies or determines various parameters required for a reception operation based on scheduling information, code parameters, and the like. The series of processes performed by the following receiver is performed based on various parameters identified and determined in this way.

An operation of the demodulation unit 610 may include several processes according to some cases. For example, the demodulation unit 610 may be subdivided into a process of obtaining a channel estimation result based on the received signal and a soft demapping process that determines values (e.g., log-likelihood ratio (LLR), or a corresponding value) necessary for decoding forward error control (FEC) corresponding to a codeword bit transmitted from a signal or symbol demodulated based on the channel estimation result. In this case, an operation within each demodulation unit may be subdivided into each channel measurement block, a soft demapping block, and the like. Of course, more diverse subdivisions are possible according to a system structure.

Hereinafter, an operation will be described on the assumption that a reception device 600 calculates and processes an LLR value for a codeword bit.

If a signal transmitted from the transmission device 500 is configured with two or more code blocks, the inverse-coupling unit 620 may distinguish the LLR for each code block by performing inverse-concatenation, which is a reverse process of the concatenation performed in the coupling unit 570 of the transmission device. If the number of code blocks is one, inverse concatenation may not be performed. Through this process, an LLR sequence for each code block is obtained, and a length of the LLR sequence for a $r$-th code block is to be $E_r$, which is a rate matching size. As with the description of the transmitter above, a series of decoding processes performed by the receiver for one code block will be described below, and the rate matching size is written as $E$ by excluding a subscript $r$, for simplicity of expression.

When interleaving is performed in the interleaving unit 560 of the transmission device 500, the deinterleaving unit 630 may perform deinterleaving, which is an inverse process thereof. This process is a process of changing the order of LLR sequence of the code block to a determined pattern, and a sequence length $E$ is not changed. The LLR sequence obtained by performing inverse-concatenation and deinterleaving in this way is written as $\Gamma = (\gamma_0, \gamma_1, \dots, \gamma_{E-1})$.

Subsequently, the rate dematching unit 640 may obtain an LLR sequence for a codeword capable of being processed by the LDPC decoder or a value equivalent thereto, by performing rate dematching, which is an inverse process of rate matching performed in the rate matching unit 550 of the transmission device 500. That is, the rate dematching unit generates a LLR sequence $\Lambda = (\lambda_0, \lambda_1, \dots, \lambda_{Ncb-1})$ for a mother codeword based on a LLR sequence $\Gamma = (\gamma_0, \gamma_1, \dots, \gamma_{E-1})$ given by the previous process. A '-th LLR $\lambda_i$ is for a mother codeword bits $x_i$.

As an example, in a case of performing rate matching using a circular buffer in 3GPP NR LDPC encoding system, the LLR sequence for the mother codeword may be generated by performing rate dematching through the following process.

1) Initialize all values of a LLR sequence $\Lambda = (\lambda_0, \lambda_1, \dots, \lambda_{Ncb-1})$ for the mother codeword to 0.
2) Set a position index for a rate dematching LLR sequence A to $i = s$. A buffer start position $S$ is a scheduling parameter, and is a value that the transmitter and the receiver may check with each other through a series of processes. Additionally, a position index for an input LLR sequence $\Gamma$ is set to $i = 0$.
3) A value of $\lambda_i$ is determined by performing one of the following operations according to the processing of a mother codeword bit determined by the encoding process performed in the transmitter.

■ If $x_i$ is shortened (a filler bit with a value of 0) in the transmitter, $\lambda_i$ is determined as a LLR value indicating that a probability of bit value 0 is maximum, or a value equivalent thereto. And increment to $i = i + 1$, and leave $j$ as it is.

■ If $x_i$ is not a shortened bit, it is determined as $\lambda_i = \lambda_i + \gamma_j$. That is, $\gamma_j$ is accumulated to an existing value of $\lambda_i$. If a decoder performs a fixed-point calculation, appropriate saturation calculation may be performed to prevent overflow. And increment to $i = i + 1$ and $j = j + 1$.

4) When an index ' for a rate dematching LLR sequence $\Lambda$ is to be $N_{cb}$ (reaching the end), it changed to $i = 0$ and set it. And repeat the process of 3) above. This repeated operation is performed until all LLRs in the input LLR sequence $\Gamma$ are reflected in the rate dematching LLR sequence $\Lambda$, that is, until the index $j$ is to be $E$.

The rate dematching unit 640 obtains a LLR sequence $\Lambda = (\lambda_0, \lambda_1, ... , \lambda_{N-1})$ for a mother codeword through the rate dematching process. As a result of the series of processes, the LLR of the shortened filler bit position is determined as the LLR value indicating that a probability of bit value 0 is maximum, or a value equivalent thereto. Since no value is written in the LLR of the punctured bit position, an initial value remains 0, which indicates that a probability of bit 0 and a probability of bit 1 are identical to 0.5, and are not biased toward either one.

In the rate dematching for the 3GPP NR LDPC encoding system in the above example, it is considered to generate a rate dematching LLR sequence of $N_{cb}$ length except for the systematic puncture bit. However, a rate dematching LLR sequence $\Lambda = (\lambda_0, \lambda_1, ... , \lambda_{N-1})$ of length $N$ may be generated by including the LLR for the systematic puncture bit according to a decoder operation. In this case, the rate dematching process may be modified and performed as follows.

1) Initialize all values of a LLR sequence $\Lambda = (\lambda_0, \lambda_1, ... , \lambda_{N-1})$ for the mother codeword to 0.

2) Set a position index for a rate dematching LLR sequence $\Lambda$ to $i = s + 2Z$. A buffer start position $S$ is a scheduling parameter, and is a value that the transmitter and the receiver may check with each other through a series of processes. Additionally, a position index for an input LLR sequence $\Gamma$ is set to $j = 0$.

3) A value of $\lambda_i$ is determined by performing one of the following operations according to the processing of a mother codeword bit determined by the encoding process performed in the transmitter.

■ If $x_i$ is shortened (a filler bit with a value of 0) in the transmitter, $\lambda_i$ is determined as a LLR value indicating that a probability of bit value 0 is maximum, or a value equivalent thereto. And increment to $i = i + 1$, and leave $j$ as it is.

■ If $x_i$ is not a shortened bit, it is determined as $\lambda_i = \lambda_i + \gamma_j$. That is, $\gamma_j$ is accumulated to an existing value of $\lambda_i$. If a decoder performs a fixed-point calculation, appropriate saturation calculation may be performed to prevent overflow. And increment to $i = i + 1$ and $j = j + 1$.

4) When an index ' for a rate dematching LLR sequence $\Lambda$ is to be $N$ (reaching the end), it changed to $i = 2Z$ and set it. And repeat the process of 3) above. This repeated operation is performed until all LLRs in the input LLR sequence $\Gamma$ are reflected in the rate dematching LLR sequence $\Lambda$, that is, until the index $j$ is to be $E$.

In the following, it is assumed that the rate dematching LLR sequence is generated without including the LLR for the systematic puncture bit, and subsequent operations are described. That is, it is assumed that the rate dematching LLR sequence is obtained as $\Lambda = (\lambda_0, \lambda_1, ... , \lambda_{Ncb-1})$. If the systematic puncture bit is considered, it is sufficient to consider that the LLR value in which a value of $2Z$ is 0 are prepended before a $\Lambda$ with length $N_{cb}$. Therefore, choosing one assumption for simplicity in the explanation does not make a difference in the final decoding result.

In a mobile communication system, HARQ operation may be performed to ensure data integrity and efficiently utilize the entire communication transmission resources. In this case, a reception device operates a HARQ LLR sequence $\Lambda^{HARQ} = (\lambda_0, \lambda_1, ... , \lambda_{Ncb-1})$ for each code block using a separate memory, and the like. In addition, the soft combining unit 650 of the reception device performs soft combining for HARQ as follows, based on $\Lambda = (\lambda_0, \lambda_1, ... , \lambda_{Ncb-1})$ and

$$\Lambda^{HARQ} = \left(\lambda_0^{HARQ}, \lambda_1^{HARQ}, ..., \lambda_{N_{cb}-1}^{HARQ}\right).$$

- If this transmission is an initial transmission (first transmission), $\Lambda_{HARQ}$ is determined as $\Lambda$. That is, substitution into $\lambda_i^{HARQ} \leftarrow \lambda_i$ for all $i = 0, 1, ... , N_{cb} - 1$ is performed. An element of a rate dematching LLR sequence $\Lambda$ is not updated separately.

- If this transmission is a retransmission (second transmission) or a subsequent transmission, elements at each position of $\Lambda_{HARQ}$ and $\Lambda$ are summed together. Specifically, for every $i = 0, 1, ... , N_{cb} - 1$, $\Lambda$ is updated in a $\lambda_i \leftarrow \lambda_i + \lambda_i^{HARQ}$ manner. $\Lambda_{HARQ}$ may be updated in consideration of various types of memory operations,

typically $\Lambda_{\text{HARQ}}$ is updated to A (for all $i = 0, 1, ..., N_{cb} - 1$, $\lambda_i^{\text{HARQ}} \leftarrow \lambda_i$ ) and then written back to the corresponding memory.

If there is no HARQ operation, the above process may be omitted.

The LDPC decoding unit 660 may receive the $\Lambda = (\lambda_0, \lambda_1, ..., \lambda_{Ncb-1})$ and perform decoding. At this time, based on code parameters (code dimension $K$, code length $N$, rate matching size $E$, code rate $K/E$, and various parameters calculated based on these, and a size of parity check matrix, and the like), the input LLR sequence A may be modified or decoding may be performed using only a portion of A. Specifically, in a case that a puncture occurs in a mother codeword due to a high transmission code rate, the receiver may reduce decoding complexity and processing time by not using a portion of the parity check matrix corresponding to punctured bits in decoding, according to the condition.

Decoding for the LDPC codes is a process of performing belief-propagation (BP) based on the LLR for codeword bits. In the BP decoding process, a message passing operation is performed that iteratively updates a posteriori LLR (AP-LLR) for the codeword bit, and the maximum number of such iterative decoding is determined based on requirements for decoding performance, time, and the like. Typically, a syndrome check is performed whenever the iterative decoding process is performed once or a specific number of times. This is a process of identifying whether the estimated bit sequence $\hat{x}$ obtained by hard decision based on the updated AP-LLR is a null space for a parity check matrix, that is, whether $H\hat{x} = 0$ is satisfied based on Equation 1, which is a condition of the LDPC code. It should be noted that in the syndrome check, only a part of the estimated bit sequence $\hat{x}$ may be considered, and in this case, the syndrome check formula may also be modified. The validity of the estimated bit sequence $\hat{x}$ decoded is identified through the syndrome check, and based on this, it is determined whether to early terminate decoding.

As described above, if the mother codeword bits are punctured, the LDPC decoder may perform decoding by using a sub parity-check matrix (sub-PCM) H' configured with a submatrix of a parity-check matrix H to reduce decoding complexity and processing time. In this case, the series of BP decoding processes may be modified according to the sub-parity check matrix H'. The decoding operation using the modified parity check matrix H' is not mandatory but is commonly used to reduce complexity. The decoding using a sub-parity check matrix is closely related to the contents of this specification, and will be described in more detail in the relation part.

The estimated bit sequence for the code block obtained after the LDPC decoding may include filler bits where a fixed information amount due to zero filling (or zero padding) performed in the zero padding unit 530 of the transmission device is absent. Therefore, the zero removal unit 670 may perform a zero removal operation that excludes filler bits from the estimated bit sequence as a inverse process of the zero filling performed in the transmitter.

If external encoding is performed with respect to the code block, a bit sequence obtained as a result of the LDPC decoding may be decoded based on the external encoding performed by the external decoding unit 680. Typically, error detection codes such as CRC codes are often concatenated, and in this case, the validity of the bit sequence obtained by the LDPC decoding is additionally checked.

If the transport block is configured with multiple code blocks, the inverse segmentation unit 690 may perform an inverse segmentation operation that concatenates results of each code block to derive a final result. This process may be understood as an inverse process of the segmentation performed in the transmission device 500.

The component illustrated in FIG. 6 is a component performing a function corresponding to the component illustrated in FIG. 6, and it is only an example, and some of the components may be omitted or changed according to a case, and another component may be added.

An LDPC encoding and decoding system according to an embodiment of the present disclosure supports a variable code dimension K (encoder input bit sequence length), a code length N (mother codeword length), and a rate matching size E (encoder output bit sequence length). In order to flexibly support such variable code parameters, a parity check matrix is constructed and transformed according to systematic rules. Hereinafter, a method for performing a flexible code dimension adjustment (variable encoding input length processing) and flexible rate matching (variable encoding output length processing) in an LDPC encoding and decoding system according to an embodiment of the present specification is described.

1) Flexible configuration of the code dimension

Most of the LDPC code systems used in practice are designed as Quasi-Cyclic LDPC (QC-LDPC) codes suitable for high-speed throughput rate implementation while supporting flexible code length adjustment. QC-LDPC codes, which belong to a structured LDPC code class, are widely used because they are suitable for obtaining high decoding throughput based on a parallelized architecture easy to define and describe a parity check matrix.

QC-LDPC codes are defined from a small base matrix. A graph that has a one-to-one correspondence to a base matrix is called a protograph or base graph (BG). The base matrix and the base graph (protograph) are treated as the same, and in the present disclosure, they are used interchangeably and have the same meaning according to the context.

The base matrix is written as $\mathbf{H}_p \in \mathbb{F}_2^{m \times n}$, the number of rows is $m = n - k$, and the number of columns is $n$. A parity check matrix $\mathbf{H} \in \mathbb{F}_2^{M \times N}$ intended to be ultimately obtained is enlarged by a copy-and-permute process of a base matrix $H_p$ and obtained. In particular, the copy-and-permute process of the QC-LDPC codes is called lifting, and a size by which $H_p$ is enlarged for configuring a parity check matrix H is called a lifting size. The lifting size is indicated by symbol $Z$. That is, a size of the parity check matrix H is $Z$ times a size of the base matrix $H_p$, and specifically, it is $K = kZ, N = nZ, M = mZ$. The lifting size $Z$ is determined so that a length of bit sequence inputted to the encoding may be processed as tightly as possible. The following references may be referenced for a lifting method and a characteristic of the QC-LDPC code designed through lifting.

Reference [Myung2006]

S. Myung, K. Yang, and Y. Kim, "Lifting methods for quasi-cyclic LDPC codes," IEEEE Commun. Lett., vol. 10, pp. 489-491, Jun. 2006.

In a process of configuring a parity check matrix H, the lifting process may be understood as replacing each element (1 × 1 scalar) of the base matrix $H_p$ with a $Z \times Z$ square matrix. For the lifting process, an exponent matrix $\mathbf{E}_p \in \mathbb{Z}_Z^{m \times n}$, which is another matrix of the same size as the base matrix, is defined. The symbol $\mathbb{Z}_z$ is a set of non-negative integers whose values are less than $Z$, as introduced earlier (i.e., $\mathbb{Z}_z = \{0, 1, \dots, Z - 1\}$). Each element of the base matrix is determined by a value thereof, and an element value in the same position in the exponent matrix. In the base matrix, an element with a value of 0 is replaced by a zero matrix (a matrix in which all elements have a value of 0) of size $Z \times Z$. In the base matrix, an element with a value of 1 are replaced by a circulant permutation matrix of size $Z \times Z$, wherein the circulant permutation matrix is a matrix obtained by circularly shifting an identity matrix of the same size $Z \times Z$ to the right by values recorded at the same positions in the exponent matrix $E_p$. By replacing each matrix of the base matrix with a $Z \times Z$ matrix in this way, a parity check matrix $\mathbf{H} \in \mathbb{F}_2^{M \times N}$ whose total size is $Z$ times larger than the base matrix $\mathbf{H}_p \in \mathbb{F}_2^{m \times n}$ is obtained ($K = kZ, N = nZ, M = mZ$).

More specifically, the lifting process may be represented by Equation 3 below.

【Equation 3】

$$(\mathbf{H})_{(jZ+\mathbb{Z}_Z) \times (iZ+\mathbb{Z}_Z)} = \begin{cases} \mathbf{P}_Z^{(\mathbf{E}_p)_{j,i}}, & \text{if } (\mathbf{H}_p)_{j,i} = 1, \\ \mathbf{0}_{Z \times Z}, & \text{if } (\mathbf{H}_p)_{j,i} = 0. \end{cases}$$

In other words, in the Equation 3, the left side $(\mathbf{H})_{(jz+zZ) \times (iZ+zZ)}$ indicates a submatrix of size $Z \times Z$ configured with $Z$ rows belonging to a set $jZ + \mathbb{Z}_Z = \{jZ, jZ + 1, \dots, jZ + Z - 1\}$ and $Z$ columns belonging to a set $iZ + \mathbb{Z}_Z = \{iZ, iZ + 1, \dots, iZ + Z - 1\}$ in the parity check matrix H. In addition, in the Equation 3, $\mathbf{P}_Z^{(\mathbf{E}_p)_{j,i}}$ is a circulant permutation matrix obtained by circularly shifting the identity matrix $I_Z$ of size $Z \times Z$ to the right by $(E_p)_{j,i}$, and $0_{Z \times Z}$ is a zero matrix of size $Z \times Z$. As shown in the Equation 3, the size $Z \times Z$ submatrix, which is configured with the $j$-th row unit and the i-th row unit of the parity check matrix H, is configured with $\mathbf{P}_Z^{(\mathbf{E}_p)_{j,i}}$ or $0_{Z \times Z}$ according to whether a value of the base matrix $H_p$ is 1 or 0. In summary, the base matrix $H_p$ determines whether there are non-zero elements of the parity check matrix H, and the exponent matrix $E_p$ determines how those non-zero elements are arranged.

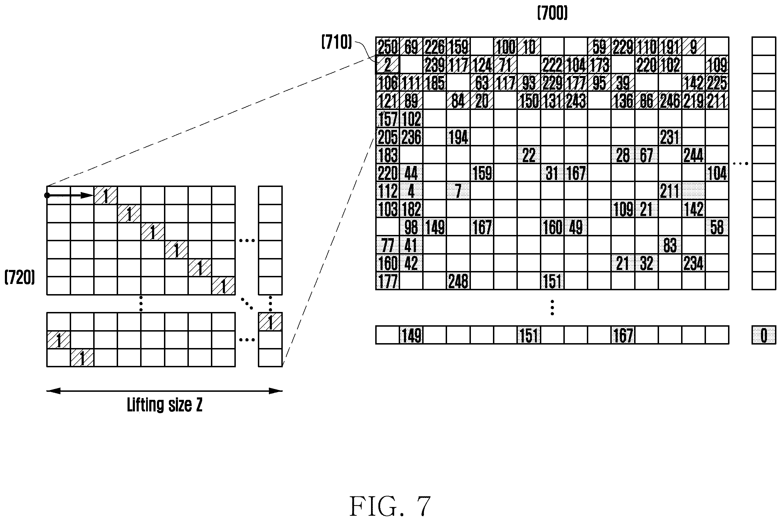

FIG. 7 is a diagram illustrating an example of a parity check matrix according to an embodiment of the present disclosure.

Hereinafter, how a parity check matrix is configured based on a lifting process will be described with reference to FIG. 7. The 700 illustrated in FIG. 7 shows a parity check matrix H in a manner of displaying elements of an exponent matrix $E_p$ on a base matrix $H_p$. That is, values written at each position of a matrix of 700 indicates a circular shift value of each circulant permutation matrix pointed to by the exponent matrix $E_p$. In the 700, a part where a value is not indicated is a part where an element is 0 in the corresponding base matrix $H_p$, and as described above, it becomes a zero matrix of size $Z \times Z$.

A part where a value is written at each position is a circulant permutation matrix of size $Z \times Z$, and the circular shift value is determined by the value written above. For example, the 710 positioned in the second row, first column of the entire parity check matrix 700 is an element with a value of 2, and this part actually indicates a circulant permutation matrix 720 of size $Z \times Z$ with a circular shift value of 2.

The QC-LDPC code configured as above adjusts a code dimension $K$ and a code length $N$ of the parity check matrix by adjusting a lifting size $Z$ value. As described above, the code dimension and length corresponding to a base matrix $H_p$ are $k$ and $n$, respectively. Based on this, the finally obtained parity check matrix H becomes $K = kZ$ and $N = nZ$, whose code dimension and length are Z times larger, respectively. Therefore, when Z is small, the code dimension $K$ and length $N$ of the finally obtained parity check matrix H become small. On the other hand, as Z increases, the code dimension and length of the finally obtained parity check matrix H increase. Based on these characteristics, the Z value may be adjusted to define parity check matrixes of various code dimensions and lengths.

The design and configuration of the LDPC codes using the lifting are not only effective in flexibly adjusting the code dimension and length, but also advantageous in designing the architecture of efficient encoders and decoders. Looking at the configuration of the circulant permutation matrix, since this matrix is configured with circular shifts of the unit matrix, only one value of 1 exists in each row and each column. Computational device units (e.g., variable node unit (VNU) and check node unit (CNU)) involved in the circulant permutation matrix may perform operations independently of each other, and results of each computational device are also not overlapping, so there is no need to keep memory conflicts in mind. For this reason, the lifting size Z may be recognized as an important parameter determining a level at which the LDPC encoder and the decoder may be parallelized.

For example, the 3GPP NR LDPC coding system defines two base graphs, BG1 and BG2, and lifts it to various sizes to obtain a parity check matrix. BG1 is used to support a situation where a code dimension and length are relatively large and a code rate is high, while BG2 is used to support a situation where the code dimension and length are relatively small, and the code rate is low. The code dimension and length of BG1 are given by $k = 22$ and $n = 68$, respectively, and the code dimension and length of BG2 are given by $k = 10$ and $n = 52$, respectively. The columns where 1 is positioned in each row of BG1 and BG2 are as shown in the table below.

[Table 1]

| Row or row block index | Column index with 1 |
|---|---|
| 0 | 0, 1, 2, 3, 5, 6, 9, 10, 11, 12, 13, 15, 16, 18, 19, 20, 21, 22, 23 |
| 1 | 0, 2, 3, 4, 5, 7, 8, 9, 11, 12, 14, 15, 16, 17, 19, 21, 22, 23, 24 |
| 2 | 0, 1, 2, 4, 5, 6, 7, 8, 9, 10, 13, 14, 15, 17, 18, 19, 20, 24, 25 |
| 3 | 0, 1, 3, 4, 6, 7, 8, 10, 11, 12, 13, 14, 16, 17, 18, 20, 21, 22, 25 |
| 4 | 0, 1, 26 |
| 5 | 0, 1, 3, 12, 16, 21, 22, 27 |
| 6 | 0, 6, 10, 11, 13, 17, 18, 20, 28 |
| 7 | 0, 1, 4, 7, 8, 14, 29 |
| 8 | 0, 1, 3, 12, 16, 19, 21, 22, 24, 30 |
| 9 | 0, 1, 10, 11, 13, 17, 18, 20, 31 |
| 10 | 1, 2, 4, 7, 8, 14, 32 |
| 11 | 0, 1, 12, 16, 21, 22, 23, 33 |
| 12 | 0, 1, 10, 11, 13, 18, 34 |
| 13 | 0, 3, 7, 20, 23, 35 |
| 14 | 0, 12, 15, 16, 17, 21, 36 |
| 15 | 0, 1, 10, 13, 18, 25, 37 |
| 16 | 1, 3, 11, 20, 22, 38 |
| 17 | 0, 14, 16, 17, 21, 39 |
| 18 | 1, 12, 13, 18, 19, 40 |
| 19 | 0, 1, 7, 8, 10, 41 |
| 20 | 0, 3, 9, 11, 22, 42 |

(continued)

| Row or row block index | Column index with 1 |
|---|---|
| 21 | 1, 5, 16, 20, 21, 43 |
| 22 | 0, 12, 13, 17, 44 |
| 23 | 1, 2, 10, 18, 45 |
| 24 | 0, 3, 4, 11, 22, 46 |
| 25 | 1, 6, 7, 14, 47 |
| 26 | 0, 2, 4, 15, 48 |
| 27 | 1, 6, 8, 49 |
| 28 | 0, 4, 19, 21, 50 |
| 29 | 1, 14, 18, 25, 51 |
| 30 | 0, 10, 13, 24, 52 |
| 31 | 1, 7, 22, 25, 53 |
| 32 | 0, 12, 14, 24, 54 |
| 33 | 1, 2, 11, 21, 55 |
| 34 | 0, 7, 15, 17, 56 |
| 35 | 1, 6, 12, 22, 57 |
| 36 | 0, 14, 15, 18, 58 |
| 37 | 1, 13, 23, 59 |
| 38 | 0, 9, 10, 12, 60 |
| 39 | 1, 3, 7, 19, 61 |
| 40 | 0, 8, 17, 62 |
| 41 | 1, 3, 9, 18, 63 |
| 42 | 0, 4, 24, 64 |
| 43 | 1, 16, 18, 25, 65 |
| 44 | 0, 7, 9, 22, 66 |
| 45 | 1, 6, 10, 67 |

[Table 1] BG1 configuration of NR LDPC code

[Table 2]

| Row or row block index | Column index with 1 |
|---|---|
| 0 | 0, 1, 2, 3, 6, 9, 10, 11 |
| 1 | 0, 3, 4, 5, 6, 7, 8, 9, 11, 12 |
| 2 | 0, 1, 3, 4, 8, 10, 12, 13 |
| 3 | 1, 2, 4, 5, 6, 7, 8, 9, 10, 13 |
| 4 | 0, 1, 11, 14 |
| 5 | 0, 1, 5, 7, 11, 15 |
| 6 | 0, 5, 7, 9, 11, 16 |
| 7 | 1, 5, 7, 11, 13, 17 |
| 8 | 0, 1, 12, 18 |
| 9 | 1, 8, 10, 11, 19 |

(continued)

| Row or row block index | Column index with 1 |
|---|---|
| 10 | 0, 1, 6, 7, 20 |
| 11 | 0, 7, 9, 13, 21 |
| 12 | 1, 3, 11, 22 |
| 13 | 0, 1, 8, 13, 23 |
| 14 | 1, 6, 11, 13, 24 |
| 15 | 0, 10, 11, 25 |
| 16 | 1, 9, 11, 12, 26 |
| 17 | 1, 5, 11, 12, 27 |
| 18 | 0, 6, 7, 28 |
| 19 | 0, 1, 10, 29 |
| 20 | 1, 4, 11, 30 |
| 21 | 0, 8, 13, 31 |
| 22 | 1, 2, 32 |
| 23 | 0, 3, 5, 33 |
| 24 | 1, 2, 9, 34 |
| 25 | 0, 5, 35 |
| 26 | 2, 7, 12, 13, 36 |
| 27 | 0, 6, 37 |
| 28 | 1, 2, 5, 38 |
| 29 | 0, 4, 39 |
| 30 | 2, 5, 7, 9, 40 |
| 31 | 1, 13, 41 |
| 32 | 0, 5, 12, 42 |
| 33 | 2, 7, 10, 43 |
| 34 | 0, 12, 13, 44 |
| 35 | 1, 5, 11, 45 |
| 36 | 0, 2, 7, 46 |
| 37 | 10, 13, 47 |
| 38 | 1, 5, 11, 48 |
| 39 | 0, 7, 12, 49 |
| 40 | 2, 10, 13, 50 |
| 41 | 1, 5, 11, 51 |

[Table 2] BG2 configuration of NR LDPC code

In the 3GPP NR LDPC encoding system, a total of 51 lifting sizes Z are defined for each BG $H_p$, from 2 to 384. Specifically, the lifting size Z is determined by one value of {2, 3, 4, 5, 6, 7, 8, 9, 10, 11, 12, 13, 14, 15, 16, 18, 20, 22, 24, 26, 28, 30, 32, 36, 40, 44, 48, 52, 56, 60, 64, 72, 80, 88, 96, 104, 112, 120, 128, 144, 160, 176, 192, 208, 224, 240, 256, 288, 320, 352, 384}, and based on this value, the exponent matrix $E_p$ is determined by a modulo lifting method. Therefore, the code dimension of the parity check matrix H obtained from BG1 ranges from $22 \times 2 = 44$ to $22 \times 384 = 8448$. Additionally, the code dimension of the parity check matrix H obtained from BG2 ranges from $10 \times 2 = 20$ to $10 \times 384 = 3840$. In this way, the 3GPP NR LDPC encoding system supports encoding and decoding for code dimensions of various lengths. If the size B of the given externally encoded code block is not equal to one of the code dimensions defined by the 51 lifting sizes, the code dimension *lf* is determined as the smallest value greater than *B*, and *F* = *K* - *B* filler bits are added to align the code dimension.

Specifically, each base matrix $H_p$ and exponent matrix $E_p$ are defined in the following reference document [TS38.212] that defines the 3GPP NR standard.

Reference [TS38.212]

NR multiplexing and channel coding (Release 16), document TSG RAN TS38.212 v16.3.0, Sept. 2020.

2) Flexible configuration of the code rate

As described in the operation of the transmitter and receiver above, the number of encoded bits transmitted (i.e., rate matching size *E*) is variably determined by various factors related to scheduling. Therefore, the LDPC code of the present disclosure is designed to flexibly support a rate matching size *E* that changes variably. In other words, this means flexibly adjusting the code rate *R* = *K/E.* For effective rate matching and the resulting low-complexity encoding and decoding operations, a two-step encoding method is used. For example, the LDPC code of the 3GPP NR system is configured with a concatenated coding scheme configured with precoding and a single parity-check extension (SPC extension) for effective rate matching. Hereinafter, a method for flexibly adjusting the code rate by the 3GPP NR LDPC code configured by the concatenation of precoding and SPC extension is introduced.

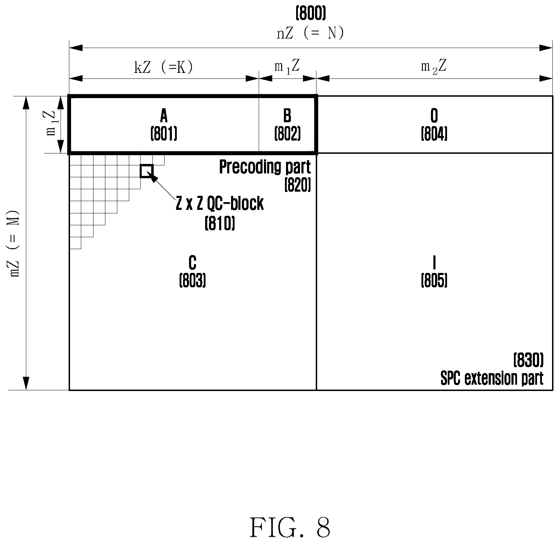

FIG. 8 is a diagram illustrating an example of a parity check matrix configured with a plurality of submatrix according to an embodiment of the present disclosure.

As illustrated in FIG. 8, a parity check matrix H 800 of 3GPP NR QC-LDPC code is configured with five sub-matrixes $\mathbf{A} \in \mathbb{F}_2^{m_1 Z \times kZ}$ 801, $\mathbf{B} \in \mathbb{F}_2^{m_1 Z \times m_1 Z}$ 802, $\mathbf{C} \in \mathbb{F}_2^{m_2 Z \times (k+m_1)Z}$ 803, $\mathbf{0} \in \mathbb{F}_2^{m_1 Z \times m_2 Z}$ 804, and $\mathbf{I} \in \mathbb{F}_2^{m_2 Z \times m_2 Z}$ 805. As described above, the parity check matrix of the QC-LDPC code is configured with a circulant permutation matrix 810 of size $Z \times Z$, and each submatrix is also configured with such a circulant permutation matrix. Herein, $m_1 + m_2 = m$, and is fixed to $m_1 = 4$ in the 3GPP NR LDPC encoding system. A configuration of the parity check matrix H 800 may be expressed as Equation 4 below.

【Equation 4】

$$\mathbf{H} = \begin{bmatrix} \mathbf{A} & \mathbf{B} & \mathbf{0} \\ \mathbf{C} & & \mathbf{I} \end{bmatrix}$$

As illustrated in FIG. 8, the submatrix **[A B]** configured with A and B in the Equation is a submatrix 820 defined for pre-coding, and other three submatrixes C, 0, I surrounding it are a submatrix 830 defined for SPC expansion.

The codeword bit vector $\mathbf{x} \in \mathbb{F}_2^{nZ}$ defined by Equation 1 based on the parity check matrix H 800 is configured with encoding input bit vector $\mathbf{u} \in \mathbb{F}_2^{kZ}$, a first parity bit vector $\mathbf{P}_1 \in \mathbb{F}_2^{m_1 Z}$, and a second parity bit vector $\mathbf{P}_2 \in \mathbb{F}_2^{m_2 Z}$, and specifically, is configured with $\mathbf{x} = [\mathbf{u}^T, \mathbf{p}_1^T, \mathbf{p}_2^T]^T$ by concatenating the three vectors. As previously described, unless otherwise stated, the vector indicates a column vector. The first parity bit vector $P_1$ is obtained by precoding information bit vector u, and this process is performed based on the submatrix 820 configured with [A B]. Pre-coding is performed as a process of obtaining $P_1$ so as to satisfy Equation 5 below.

【Equation 5】

$$[\mathbf{A} \quad \mathbf{B}] \begin{bmatrix} \mathbf{u} \\ \mathbf{P}_1 \end{bmatrix} = \mathbf{0}$$

$[\mathbf{u}^T, \mathbf{p}_1^T]^T$ in the Equation 5 indicates the concatenation of two vectors u and $P_1$ to columns. The $[\mathbf{u}^T, \mathbf{p}_1^T]^T$ obtained by pre-coding is encoded again using the SPC extension method, thereby generating the second parity bit vector Pz. Specifically, the SPC extension encoding is performed based on the submatrix 830 of FIG. 8 to satisfy Equation 6 below.

【Equation 6】

$$[\mathbf{C} \quad \mathbf{I}]\begin{bmatrix} \mathbf{u} \\ \mathbf{P_1} \\ \mathbf{P_2} \end{bmatrix} = \mathbf{0}$$

In the Equation 6, a portion of the parity check matrix involved in the generation of the second parity bit vector Pz is configured with a unit matrix $\mathbf{I} \in \mathbb{F}_2^{m_2 Z \times m_2 Z}$ 805. In addition, because of a structure of the submatrix 830 corresponding to the SPC extension, that is a structure configured with $\mathbf{C} \in \mathbb{F}_2^{m_2 Z \times (k+m_1)Z}$ 803, $\mathbf{0} \in \mathbb{F}_2^{m_1 Z \times m_2 Z}$ 804, and $\mathbf{I} \in \mathbb{F}_2^{m_2 Z \times m_2 Z}$ 805, each parity bit of Pz is not involved in the generation of any other code bit of the codeword bit vector x. Therefore, even if some bits of Pz are punctured, it does not affect the generation of any other codeword bits of u, $P_1$, or Pz at the transmitter, or the estimation or decoding at the receiver. When the parity bits generated by the SPC extension are punctured, the parity check matrix may be easily modified by utilizing these features. Specifically, when a bit of $P_2$ generated by the SPC extension is punctured, a column in which the bit corresponds to the parity check matrix H and a row in which 1 is positioned in the column may be simultaneously deleted. Because of a configuration by the unit matrix $\mathbf{I} \in \mathbb{F}_2^{m_2 Z \times m_2 Z}$ 805, there is only one row in which 1 is positioned in the corresponding column. Specifically, if the second parity bit $x_i$ generated by the SPC extension in the codeword bit vector x is punctured, it may be seen that the '-th column and the $i - K$-th row of the parity check matrix H is capable of being deleted based on the structure of FIG. 8. By reducing a size of the parity check matrix by considering puncturing in this way, complexity and process time of decoding may be reduced. The sub-parity-check matrix (sub-PCM) whose size is reduced by considering the puncturing is written as H'.

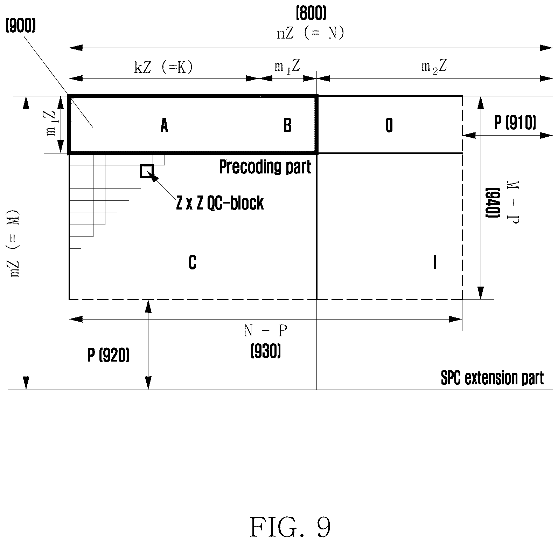

FIG. 9 is a diagram illustrating an example of a sub parity-check matrix according to an embodiment of the present disclosure.

FIG. 9 shows how a receiver configures a sub-parity check matrix H' 900 in consideration of puncturing in a 3GPP NR LDPC code system. In this embodiment, it is considered that P parity bits obtained by the SPC extension are punctured sequentially from those with a large index. That is, it is considered that P bits $x_{N-P}$, $x_{N-P+1}$, ... , $x_{N-1}$ are punctured in a generated codeword bit vector x = $(x_0, x_1, ... , x_{N-1})$. When rate matching using a circular buffer described above is actually used, since it is transmitted sequentially from the bits with smaller indexes of the codeword bit vector, so the bits with larger indexes are punctured as a result. For reference, the puncturing of a first parity bit generated by the systematic puncturing and pre-encoding does not affect a deformation of the parity check matrix.

If a second parity bit $x_{N-P}, x_{N-P+1}$, ... , $x_{N-1}$ is punctured in the codeword bit vector x, the column 910 whose index belongs to $\{N-P, N-P+1, ... , N-1\}$ and the row 920 whose index belongs to $\{M-P, M-P+1, ... , M-1\}$ may be removed in the parity check matrix H. As a result, the sub-parity check matrix $\mathbf{H}' \in \mathbb{F}_2^{(M-P) \times (N-P)}$ by puncturing is constructed as shown in Equation 7 below.

【Equation 7】

$$\mathbf{H}' = (\mathbf{H})_{\{0,1,...,M-P-1\} \times \{0,1,...,N-P-1\}}$$

That is, the sub parity check matrix H' is a submatrix obtained by taking the first $N - P$ columns 930 and the first $M - P$ rows 940 from H. The complexity and processing time may be reduced by performing decoding based on the sub-parity check matrix H', instead of performing decoding based on the entire parity check matrix H of the receiver. In addition to the decoding operation, a series of related operations (rate dematching, HARQ soft combination, and the like) are performed based on the sub parity check matrix H' to reduce complexity and processing time.

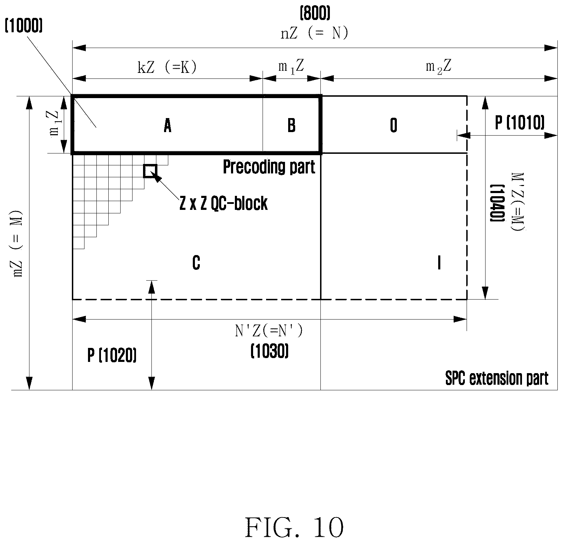

FIG. 10 is a diagram illustrating another example of a sub parity-check matrix according to an embodiment of the present disclosure.

FIG. 10 shows how a receiver configures a sub parity check matrix H' 1000 in consideration of puncturing in a 3GPP NR LDPC coding system. As described above, a QC-LDPC code is configured with a circulant permutation matrix of size $Z \times Z$, and a lifting size Z may be a parallelization level and a basic operation unit in decoder design. Therefore, the decoder may be designed and operated using a circulant permutation matrix based on a lifting size Z as a basic decoding operation unit. In this case, it is necessary to ensure that the sub parity check matrix H' considering puncturing is configured with a circulant permutation matrix of size $Z \times Z$. In other words, if the number of rows and columns of the sub-parity check matrix H' is respectively written as N' and M', N' and M' should be multiples of the lifting size Z. Therefore, if the number of puncture bits is P as in the above example, N' and M' may be determined by Equation 8 below.

**【Equation 8】**

$$N' = \left\lceil \frac{(N-P)}{Z} \right\rceil \times Z = \left( \frac{N}{Z} - \left\lfloor \frac{P}{Z} \right\rfloor \right) \times Z = N - \left\lfloor \frac{P}{Z} \right\rfloor \times Z$$

$$M' = \left\lceil \frac{(M-P)}{Z} \right\rceil \times Z = \left( \frac{M}{Z} - \left\lfloor \frac{P}{Z} \right\rfloor \right) \times Z = M - \left\lfloor \frac{P}{Z} \right\rfloor \times Z$$

The Equation 8 is derived from the fact that N and M are multiples of Z in the QC-LDPC code. If F is not a multiple of Z, rows and columns for $P - \lfloor P/Z \rfloor \times Z$ punctured second parity bits may remain in the sub parity check matrix H' configured as shown in 1010 and 1020 of FIG. 10. Of course, if no puncturing occurs or P is less than Z, the sub parity check matrix H' is identical to the entire parity check matrix H.

In the above Equation 8, if $\lfloor P/Z \rfloor = p$, n' = n - p and m' = m - p, N' = n'Z 1030 and M' = m'Z 1040 may be used. In the above, n' and m' indicate the number of circulant permutation matrix in the columns and rows to be processed when the sub-parity check matrix H' of size $M' \times N''$ is used in the LDPC code system. In other words, the LDPC code system processes n' circulant permutation matrix in columns and m' circulant permutation matrix in rows. Hereinafter, embodiments of the present specification are described in consideration of configuring a sub-parity check matrix $\mathbf{H}' \in \mathbb{F}_2^{m'Z \times n'Z}$ based on a multiple of the lifting size Z, as shown in the embodiment of FIG. 10. However, the present specification is not limited to a method of configuring a specific sub-parity check matrix.

The present specification relates to specific methods and embodiments for performing layered decoding based on a sub-parity check matrix $\mathbf{H}' \in \mathbb{F}_2^{m'Z \times n'Z}$ configured as described above. The layered decoding is a decoding method that divides a given parity check matrix into row-unit submatrices called layers, and sequentially performs decoding for each submatrix. Since rows belonging to each layer are capable of being processed in parallel if possible, layered decoding method may be classified as a sub-sequential method. For example, in a case of the QC-LDPC code, internal components of each circulant permutation matrix do not depend on each other, so they may be processed independently. Therefore, layered decoding for the QC-LDPC code sets the Z row-unit submatrices configured with circulant permutation matrixes as a layer, and may process them in parallel within a short processing time and few cycles. Because of these characteristics, the parallelization level of QC-LDPC codes may be at least Z.

For convenience, in this specification, a Z row unit submatrix distinguished based on the $Z \times Z$ circulant permutation matrixes in the parity check matrix of QC-LDPC is called a row-block, and a Z column unit submatrix is called a column-block. If only a part of the parity check matrix is used, such as a sub-parity check matrix, a row block or column block may be defined based on a part of the parity check matrix.

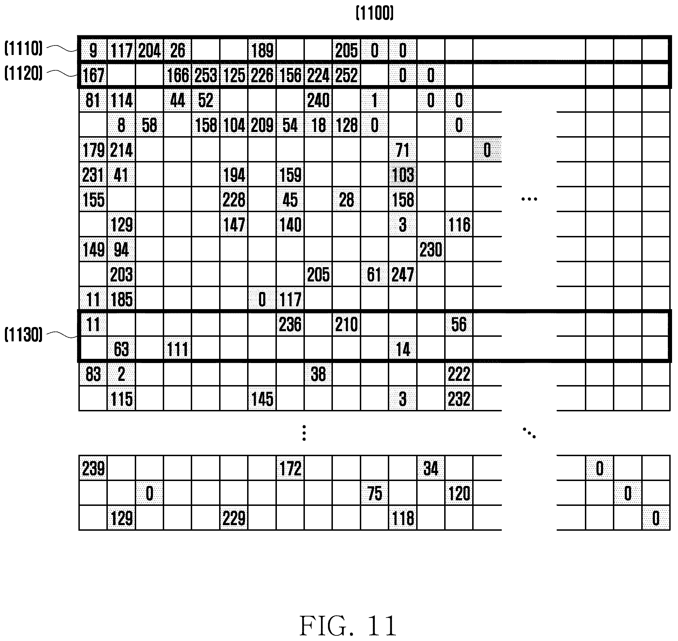

FIG. 11 is a diagram illustrating an example of a parity check matrix H 1100 configured based on BG2 in a 3GPP NR LDPC code system. As shown in FIG. 7, the parity check matrix H of FIG. 11 is indicated in a form of displaying the elements of the exponent matrix $E_p$ at a position where elements are 1 in the corresponding base matrix $H_p$. Each row and column separated In this diagram actually has a lifting size Z. In layered decoding, submatrices configured with Z row units indicated as 1110 and 1120 is designed to be set and processed as a layer. In addition, layered decoding may be designed to process rows and columns corresponding to each layer configured as in 1110 at once, or may be designed to process layers by dividing them into smaller submatrices. However, layered decoding sequentially performs decoding for other submatrices after completing decoding for a specific layer.

In layered decoding for QC-LDPC codes, some layers may include two or more orthogonal submatrices of Z-row-unit, that is row blocks. Herein, orthogonal means that there is no 1 in the same column for two or more target rows or row blocks. For example, in FIG. 11, 1130 indicates two orthogonal submatrices of Z-row unit, and each row has at most one non-zero element. Since these orthogonal rows or row blocks are not dependent on each other and may be processed in parallel, layered decoding may efficiently process them by grouping them into one layer.

In conventional layered decoding, the order of layers being processed is determined based on the form of the given parity check matrix. For example, in FIG. 11, a natural order method is generally used, in which the layers configured with 1110 are processed in the order of rows or row blocks, and then the layers configured with 1120 are processed.

As another example, a layer scheduling method that determines the order of layers by mixing them into a specific pattern may be used. In this method, 1120 may be processed before 1110. The layer order in this layer scheduling should be carefully designed to improve decoding performance and reduce the number of iterative decoding required for successful decoding.

The present specification relates to an efficient layer scheduling that further improves error-correction performance and further reduces decoding time in layered decoding of LDPC codes. The layer scheduling of this specification is designed and operated by considering 1) the configuration of a sub-parity check matrix that changes variably by puncturing and 2) simultaneous processing of orthogonal rows or row blocks.

As described in detail above, in the LDPC code system to which the present specification can be applied, a size of the sub-parity check matrix used by the decoder may be changed according to a code rate (according to the number of bits to be punctured). In other words, the number $m'$ of circulant permutation matrix in the row unit of the constructed sub-parity check matrix H'may be changed for each decoding operation. In this case, the layered decoder must design and operate layer scheduling for all possible $m'$ cases. For more efficient operation, the present specification proposes a layer scheduling method that designs a mother layer scheduling sequence and derives a sub layer scheduling sequence for a given $m'$ based on the designed mother layer scheduling sequence. In the following description, the layer scheduling sequence may mean a sequence that lists indices of rows or row blocks constituting a parity check matrix or a sub-parity check matrix, or a group of indices corresponding to two or more rows or row blocks in the order in which they are processed in layered decoding. Each index included in the layer scheduling sequence may correspond to one row or one row block of the parity check matrix.

Hereinafter, a specific embodiment of the present specification is described. In the following description, the entire layer scheduling sequence is written as $\mathcal{S}_m = (s_0, s_1, \ldots, s_{m-1})$, and the sub-layer scheduling sequence for a given $m'$ ($m' \leq m$) is expressed as $\mathcal{S}_{m'} = (s_0, s_1, \ldots, s_{m'-1})$. According to an embodiment of the present specification, the sub-layer scheduling sequence $\mathcal{S}_{m'}$ is configured by sequentially reading the entire layer scheduling sequence $\mathcal{S}_m$ and taking elements smaller than m'. For example, it is assumed that the entire layer scheduling sequence is given as $\mathcal{S}_m = (10, 6, 4, 7, 5, 9, 8, 3, 1, 0, 2)$. Based on the entire layer scheduling sequence $\mathcal{S}_m$, the sub-layer scheduling sequence for $m' = 6$ may be determined as $\mathcal{S}_{m'} = (4, 5, 3, 1, 0, 2)$ in which elements smaller than $m' = 6$ are sequentially taken in the entire layer scheduling sequence $\mathcal{S}_m$ in the manner described above. The entire layer scheduling sequence used in this manner is called a nested sequence. In this way, according to the present specification, it is possible to flexibly support layer scheduling for a variable sub-parity check matrix while operating only one sequence.

The entire layer sequence is designed in advance and reflected in the system and decoder. This entire layer sequence may be written to memory or used to configure a modified parity check matrix described later. That is, in an actual decoding operation, the layer sequence may be simply identified by simply reading the sequence written to memory or using the already reflected modified parity check matrix.

In addition, according to an embodiment of the present specification, the layered decoding method may perform layer scheduling so that as many orthogonal rows or row blocks as possible may be processed simultaneously in a parity check matrix. By checking a structure of the given entire parity check matrix H, the layer scheduling is designed and operated so that as many orthogonal rows or row blocks as possible are processed at once. For example, in case of layered decoding in a natural order, the parity check matrix H defined by BG2 of FIG. 11 may group a total of 42 rows or row blocks in the same manner as shown in Table 3 below and process a total of 28 layers.

[Table 3]

| 0, 1, 2, 3, 4, 5, 6, 7, 8, 9, 10, (11, 12), 13, 14, 15, 16, (17, 18), 19, (20, 21), (22, 23), (24, 25), (26, 27), (28, 29), (30, 31), (32, 33), (34, 35), (36, 37, 38), (39, 40, 41) |
| --- |

In the above configuration, the rows or row blocks of the index enclosed in parentheses may be configured as one layer, and the rows or row blocks enclosed in one parentheses may be orthogonal rows or row blocks to each other. (In a case that multiple orthogonal rows or row blocks are processed as one layer, the total number of layers for layered decoding is always smaller than the number of row blocks of the parity check matrix.) In an embodiment of the present specification, more row or row blocks are configured as one layer in consideration of that the order of layers may be mixed in layer scheduling. As an embodiment of the present specification, for the BG2, the entire 42 row blocks are grouped in the same manner as shown in Table 4 below and processed into a total of 23 layers.

[Table 4]

| 0, (1, 22, 37), 2, 3, 4, 5, (6, 31), (7, 29), 8, (9, 25, 26), 10, (11, 17), (12, 36), 13, (14, 32, 33), (15, 28), (16, 23, 40), (18, 38), 19, (20, 21, 30), (24, 39), (27, 35), (34, 41) |
| --- |

As described above, in the present specification, the total number of layers may be reduced from 28 to 23 by identifying more orthogonal row or row blocks and grouping orthogonal row or row blocks in a more efficient way by mixing the order of each row or row blocks. Considering that the total processing time in layered decoding is proportional to the number of layers, the method according to an embodiment of the present disclosure may reduce the total decoding time by about 28% (= (28 - 23)/28). As an embodiment of the present specification, layer scheduling for decoding of 3GPP NR LDPC codes is described. All parity check matrices used in 3GPP NR LDPC code system are derived from two base matrices, BG1 and BG2. Therefore, in an embodiment of the present specification, for a 3GPP NR LDPC code system, the following two nested layer scheduling sequences $S_{46}^{(BG1)}$ and $S_{42}^{(BG2)}$ are used for parity check matrices defined based on BG1 and BG2, respectively. Layer scheduling sequence $S_{46}^{(BG1)}$ for BG1 :

[(42, 43), (37, 36), (27, 26), (40, 41), (45, 44), (28, 29), (30, 31), (22, 23), (32, 33), (34, 35), (38, 39), (25, 24), 13, (17, 18), (16, 14), (10, 6), (20, 21), 4, 19, 7, 12, 15, 5, 11, 9, 8, 3, 1, 0, 2].

Layer scheduling sequence $S_{42}^{(BG2)}$ for BG2 :

[(27, 35), (18, 38), (15, 28), (24, 39), (12, 36), (25, 9, 26), (31, 6), (33, 32, 14), (29, 7), (34, 41), (20, 21, 30), (11, 17), 8, (40, 23, 16), 19, 4, 13, 10, 5, 2, (22, 37, 1), 0, 3]

In the layer scheduling sequence, row or row blocks corresponding to an index grouped by one parenthesis may constitute one layer, and as described above, each layer of the layer scheduling sequence may correspond to a plurality of layers corresponding to one or a plurality of indexes.

In the above layer scheduling sequence notation, the rows or row blocks of the indices included in one parenthesis are orthogonal and may be processed in parallel according to the implementation of layered decoding. In addition, in the above layer scheduling sequence notation, the rows or row blocks of the indices included in one parenthesis are orthogonal but may be processed sequentially according to the implementation of layered decoding.

Tables 5 and 6 below illustrate the sub-layer scheduling sequences $S_{m'}^{(BG1)}$ and $S_{m'}^{(BG2)}$ used when $m'$ of the sub-parity check matrix is given based on the two layer scheduling sequences $S_{46}^{(BG1)}$ and $S_{42}^{(BG2)}$. The maximum value of $m'$ is $m$, and the minimum value is 4, which is the index of the row block where the SPC expansion starts.

[Table 5]

| Num ber of Row ($m'$) | Sub layer scheduling sequence $S_{m'}^{(BG1)}$ |
|---|---|
| 46 | (42, 43), (37, 36), (27, 26), (40, 41), (45, 44), (28, 29), (30, 31), (22, 23), (32, 33), (34, 35), (38, 39), (25, 24), 13, (17, 18), (16, 14), (10, 6), (20, 21), 4, 19, 7, 12, 15, 5, 11, 9, 8, 3, 1, 0, 2 |
| 45 | (42, 43), (37, 36), (27, 26), (40, 41), 44, (28, 29), (30, 31), (22, 23), (32, 33), (34, 35), (38, 39), (25, 24), 13, (17, 18), (16, 14), (10, 6), (20, 21), 4, 19, 7, 12, 15, 5, 11, 9, 8, 3, 1, 0, 2 |
| 44 | (42, 43), (37, 36), (27, 26), (40, 41), (28, 29), (30, 31), (22, 23), (32, 33), (34, 35), (38, 39), (25, 24), 13, (17, 18), (16, 14), (10, 6), (20, 21), 4, 19, 7, 12, 15, 5, 11, 9, 8, 3, 1, 0, 2 |
| 43 | 42, (37, 36), (27, 26), (40, 41), (28, 29), (30, 31), (22, 23), (32, 33), (34, 35), (38, 39), (25, 24), 13, (17, 18), (16, 14), (10, 6), (20, 21), 4, 19, 7, 12, 15, 5, 11, 9, 8, 3, 1, 0, 2 |
| 42 | (37, 36), (27, 26), (40, 41), (28, 29), (30, 31), (22, 23), (32, 33), (34, 35), (38, 39), (25, 24), 13, (17, 18), (16, 14), (10, 6), (20, 21), 4, 19, 7, 12, 15, 5, 11, 9, 8, 3, 1, 0, 2 |
| 41 | (37, 36), (27, 26), 40, (28, 29), (30, 31), (22, 23), (32, 33), (34, 35), (38, 39), (25, 24), 13, (17, 18), (16, 14), (10, 6), (20, 21), 4, 19, 7, 12, 15, 5, 11, 9, 8, 3, 1, 0, 2 |
| 40 | (37, 36), (27, 26), (28, 29), (30, 31), (22, 23), (32, 33), (34, 35), (38, 39), (25, 24), 13, (17, 18), (16, 14), (10, 6), (20, 21), 4, 19, 7, 12, 15, 5, 11, 9, 8, 3, 1, 0, 2 |
| 39 | (37, 36), (27, 26), (28, 29), (30, 31), (22, 23), (32, 33), (34, 35), 38, (25, 24), 13, (17, 18), (16, 14), (10, 6), (20, 21), 4, 19, 7, 12, 15, 5, 11, 9, 8, 3, 1, 0, 2 |
| 38 | (37, 36), (27, 26), (28, 29), (30, 31), (22, 23), (32, 33), (34, 35), (25, 24), 13, (17, 18), (16, 14), (10, 6), (20, 21), 4, 19, 7, 12, 15, 5, 11, 9, 8, 3, 1, 0, 2 |

(continued)

| Num ber of Row (*m'*) | Sub layer scheduling sequence $\delta_{m'}^{(BG1)}$ |
|---|---|
| 37 | 36, (27, 26), (28, 29), (30, 31), (22, 23), (32, 33), (34, 35), (25, 24), 13, (17, 18), (16, 14), (10, 6), (20, 21), 4, 19, 7, 12, 15, 5, 11, 9, 8, 3, 1, 0, 2 |
| 36 | (27, 26), (28, 29), (30, 31), (22, 23), (32, 33), (34, 35), (25, 24), 13, (17, 18), (16, 14), (10, 6), (20, 21), 4, 19, 7, 12, 15, 5, 11, 9, 8, 3, 1, 0, 2 |
| 35 | (27, 26), (28, 29), (30, 31), (22, 23), (32, 33), 34, (25, 24), 13, (17, 18), (16, 14), (10, 6), (20, 21), 4, 19, 7, 12, 15, 5, 11, 9, 8, 3, 1, 0, 2 |
| 34 | (27, 26), (28, 29), (30, 31), (22, 23), (32, 33), (25, 24), 13, (17, 18), (16, 14), (10, 6), (20, 21), 4, 19, 7, 12, 15, 5, 11, 9, 8, 3, 1, 0, 2 |
| 33 | (27, 26), (28, 29), (30, 31), (22, 23), 32, (25, 24), 13, (17, 18), (16, 14), (10, 6), (20, 21), 4, 19, 7, 12, 15, 5, 11, 9, 8, 3, 1, 0, 2 |
| 32 | (27, 26), (28, 29), (30, 31), (22, 23), (25, 24), 13, (17, 18), (16, 14), (10, 6), (20, 21), 4, 19, 7, 12, 15, 5, 11, 9, 8, 3, 1, 0, 2 |
| 31 | (27, 26), (28, 29), 30, (22, 23), (25, 24), 13, (17, 18), (16, 14), (10, 6), (20, 21), 4, 19, 7, 12, 15, 5, 11, 9, 8, 3, 1, 0, 2 |
| 30 | (27, 26), (28, 29), (22, 23), (25, 24), 13, (17, 18), (16, 14), (10, 6), (20, 21), 4, 19, 7, 12, 15, 5, 11, 9, 8, 3, 1, 0, 2 |
| 29 | (27, 26), 28, (22, 23), (25, 24), 13, (17, 18), (16, 14), (10, 6), (20, 21), 4, 19, 7, 12, 15, 5, 11, 9, 8, 3, 1, 0, 2 |
| 28 | (27, 26), (22, 23), (25, 24), 13, (17, 18), (16, 14), (10, 6), (20, 21), 4, 19, 7, 12, 15, 5, 11, 9, 8, 3, 1, 0, 2 |
| 27 | 26, (22, 23), (25, 24), 13, (17, 18), (16, 14), (10, 6), (20, 21), 4, 19, 7, 12, 15, 5, 11, 9, 8, 3, 1, 0, 2 |
| 26 | (22, 23), (25, 24), 13, (17, 18), (16, 14), (10, 6), (20, 21), 4, 19, 7, 12, 15, 5, 11, 9, 8, 3, 1, 0, 2 |
| 25 | (22, 23), 24, 13, (17, 18), (16, 14), (10, 6), (20, 21), 4, 19, 7, 12, 15, 5, 11, 9, 8, 3, 1, 0, 2 |
| 24 | (22, 23), 13, (17, 18), (16, 14), (10, 6), (20, 21), 4, 19, 7, 12, 15, 5, 11, 9, 8, 3, 1, 0, 2 |
| 23 | 22, 13, (17, 18), (16, 14), (10, 6), (20, 21), 4, 19, 7, 12, 15, 5, 11, 9, 8, 3, 1, 0, 2 |
| 22 | 13, (17, 18), (16, 14), (10, 6), (20, 21), 4, 19, 7, 12, 15, 5, 11, 9, 8, 3, 1, 0, 2 |
| 21 | 13, (17, 18), (16, 14), (10, 6), 20, 4, 19, 7, 12, 15, 5, 11, 9, 8, 3, 1, 0, 2 |
| 20 | 13, (17, 18), (16, 14), (10, 6), 4, 19, 7, 12, 15, 5, 11, 9, 8, 3, 1, 0, 2 |
| 19 | 13, (17, 18), (16, 14), (10, 6), 4, 7, 12, 15, 5, 11, 9, 8, 3, 1, 0, 2 |
| 18 | 13, 17, (16, 14), (10, 6), 4, 7, 12, 15, 5, 11, 9, 8, 3, 1, 0, 2 |
| 17 | 13, (16, 14), (10, 6), 4, 7, 12, 15, 5, 11, 9, 8, 3, 1, 0, 2 |
| 16 | 13, 14, (10, 6), 4, 7, 12, 15, 5, 11, 9, 8, 3, 1, 0, 2 |
| 15 | 13, 14, (10, 6), 4, 7, 12, 5, 11, 9, 8, 3, 1, 0, 2 |
| 14 | 13, (10, 6), 4, 7, 12, 5, 11, 9, 8, 3, 1, 0, 2 |
| 13 | (10, 6), 4, 7, 12, 5, 11, 9, 8, 3, 1, 0, 2 |
| 12 | (10, 6), 4, 7, 5, 11, 9, 8, 3, 1, 0, 2 |
| 11 | (10, 6), 4, 7, 5, 9, 8, 3, 1, 0, 2 |
| 10 | 6, 4, 7, 5, 9, 8, 3, 1, 0, 2 |
| 9 | 6, 4, 7, 5, 8, 3, 1, 0, 2 |
| 8 | 6, 4, 7, 5, 3, 1, 0, 2 |

(continued)

| Num ber of Row (*m'*) | Sub layer scheduling sequence $\delta_{m'}^{(BG1)}$ |
|---|---|
| 7 | 6, 4, 5, 3, 1, 0, 2 |
| 6 | 4, 5, 3, 1, 0, 2 |
| 5 | 4, 3, 1, 0, 2 |
| 4 | 3, 1, 0, 2 |

[Table 5] Layer scheduling sequence for BG1 of 3GPP NR LDPC code

[Table 6]

| Number of Row (*m'*) | Layer scheduling sequence $\delta_{m'}^{(BG2)}$ |
|---|---|
| 42 | (27, 35), (18, 38), (15, 28), (24, 39), (12, 36), (25, 9, 26), (31, 6), (33, 32, 14), (29, 7), (34, 41), (20, 21, 30), (11, 17), 8, (40, 23, 16), 19, 4, 13, 10, 5, 2, (22, 37, 1), 0, 3 |
| 41 | (27, 35), (18, 38), (15, 28), (24, 39), (12, 36), (25, 9, 26), (31, 6), (33, 32, 14), (29, 7), 34, (20, 21, 30), (11, 17), 8, (40, 23, 16), 19, 4, 13, 10, 5, 2, (22, 37, 1), 0, 3 |
| 40 | (27, 35), (18, 38), (15, 28), (24, 39), (12, 36), (25, 9, 26), (31, 6), (33, 32, 14), (29, 7), 34, (20, 21, 30), (11, 17), 8, (23, 16), 19, 4, 13, 10, 5, 2, (22, 37, 1), 0, 3 |
| 39 | (27, 35), (18, 38), (15, 28), 24, (12, 36), (25, 9, 26), (31, 6), (33, 32, 14), (29, 7), 34, (20, 21, 30), (11, 17), 8, (23, 16), 19, 4, 13, 10, 5, 2, (22, 37, 1), 0, 3 |
| 38 | (27, 35), 18, (15, 28), 24, (12, 36), (25, 9, 26), (31, 6), (33, 32, 14), (29, 7), 34, (20, 21, 30), (11, 17), 8, (23, 16), 19, 4, 13, 10, 5, 2, (22, 37, 1), 0, 3 |
| 37 | (27, 35), 18, (15, 28), 24, (12, 36), (25, 9, 26), (31, 6), (33, 32, 14), (29, 7), 34, (20, 21, 30), (11, 17), 8, (23, 16), 19, 4, 13, 10, 5, 2, (22, 1), 0, 3 |
| 36 | (27, 35), 18, (15, 28), 24, 12, (25, 9, 26), (31, 6), (33, 32, 14), (29, 7), 34, (20, 21, 30), (11, 17), 8, (23, 16), 19, 4, 13, 10, 5, 2, (22, 1), 0, 3 |
| 35 | 27, 18, (15, 28), 24, 12, (25, 9, 26), (31, 6), (33, 32, 14), (29, 7), 34, (20, 21, 30), (11, 17), 8, (23, 16), 19, 4, 13, 10, 5, 2, (22, 1), 0, 3 |
| 34 | 27, 18, (15, 28), 24, 12, (25, 9, 26), (31, 6), (33, 32, 14), (29, 7), (20, 21, 30), (11, 17), 8, (23, 16), 19, 4, 13, 10, 5, 2, (22, 1), 0, 3 |
| 33 | 27, 18, (15, 28), 24, 12, (25, 9, 26), (31, 6), (32, 14), (29, 7), (20, 21, 30), (11, 17), 8, (23, 16), 19, 4, 13, 10, 5, 2, (22, 1), 0, 3 |
| 32 | 27, 18, (15, 28), 24, 12, (25, 9, 26), (31, 6), 14, (29, 7), (20, 21, 30), (11, 17), 8, (23, 16), 19, 4, 13, 10, 5, 2, (22, 1), 0, 3 |
| 31 | 27, 18, (15, 28), 24, 12, (25, 9, 26), 6, 14, (29, 7), (20, 21, 30), (11, 17), 8, (23, 16), 19, 4, 13, 10, 5, 2, (22, 1), 0, 3 |
| 30 | 27, 18, (15, 28), 24, 12, (25, 9, 26), 6, 14, (29, 7), (20, 21), (11, 17), 8, (23, 16), 19, 4, 13, 10, 5, 2, (22, 1), 0, 3 |
| 29 | 27, 18, (15, 28), 24, 12, (25, 9, 26), 6, 14, 7, (20, 21), (11, 17), 8, (23, 16), 19, 4, 13, 10, 5, 2, (22, 1), 0, 3 |
| 28 | 27, 18, 15, 24, 12, (25, 9, 26), 6, 14, 7, (20, 21), (11, 17), 8, (23, 16), 19, 4, 13, 10, 5, 2, (22, 1), 0, 3 |
| 27 | 18, 15, 24, 12, (25, 9, 26), 6, 14, 7, (20, 21), (11, 17), 8, (23, 16), 19, 4, 13, 10, 5, 2, (22, 1), 0, 3 |

(continued)

| Number of Row ($m'$) | Layer scheduling sequence $\mathcal{S}_{m'}^{(BG2)}$ |
|---|---|
| 26 | 18, 15, 24, 12, (25, 9), 6, 14, 7, (20, 21), (11, 17), 8, (23, 16), 19, 4, 13, 10, 5, 2, (22, 1), 0, 3 |
| 25 | 18, 15, 24, 12, 9, 6, 14, 7, (20, 21), (11, 17), 8, (23, 16), 19, 4, 13, 10, 5, 2, (22, 1), 0, 3 |
| 24 | 18, 15, 12, 9, 6, 14, 7, (20, 21), (11, 17), 8, (23, 16), 19, 4, 13, 10, 5, 2, (22, 1), 0, 3 |
| 23 | 18, 15, 12, 9, 6, 14, 7, (20, 21), (11, 17), 8, 16, 19, 4, 13, 10, 5, 2, (22, 1), 0, 3 |
| 22 | 18, 15, 12, 9, 6, 14, 7, (20, 21), (11, 17), 8, 16, 19, 4, 13, 10, 5, 2, 1, 0, 3 |
| 21 | 18, 15, 12, 9, 6, 14, 7, 20, (11, 17), 8, 16, 19, 4, 13, 10, 5, 2, 1, 0, 3 |
| 20 | 18, 15, 12, 9, 6, 14, 7, (11, 17), 8, 16, 19, 4, 13, 10, 5, 2, 1, 0, 3 |
| 19 | 18, 15, 12, 9, 6, 14, 7, (11, 17), 8, 16, 4, 13, 10, 5, 2, 1, 0, 3 |
| 18 | 15, 12, 9, 6, 14, 7, (11, 17), 8, 16, 4, 13, 10, 5, 2, 1, 0, 3 |
| 17 | 15, 12, 9, 6, 14, 7, 11, 8, 16, 4, 13, 10, 5, 2, 1, 0, 3 |
| 16 | 15, 12, 9, 6, 14, 7, 11, 8, 4, 13, 10, 5, 2, 1, 0, 3 |
| 15 | 12, 9, 6, 14, 7, 11, 8, 4, 13, 10, 5, 2, 1, 0, 3 |
| 14 | 12, 9, 6, 7, 11, 8, 4, 13, 10, 5, 2, 1, 0, 3 |
| 13 | 12, 9, 6, 7, 11, 8, 4, 10, 5, 2, 1, 0, 3 |
| 12 | 9, 6, 7, 11, 8, 4, 10, 5, 2, 1, 0, 3 |
| 11 | 9, 6, 7, 8, 4, 10, 5, 2, 1, 0, 3 |
| 10 | 9, 6, 7, 8, 4, 5, 2, 1, 0, 3 |
| 9 | 6, 7, 8, 4, 5, 2, 1, 0, 3 |
| 8 | 6, 7, 4, 5, 2, 1, 0, 3 |
| 7 | 6, 4, 5, 2, 1, 0, 3 |
| 6 | 4, 5, 2, 1, 0, 3 |
| 5 | 4, 2, 1, 0, 3 |
| 4 | 2, 1, 0, 3 |

[Table 6] Layer scheduling sequence for BG2 of NR LDPC code

According to an embodiment of the present disclosure, a layered decoder records or stores entire layer scheduling sequences $\mathcal{S}_{m}^{(BG1)}$ and $\mathcal{S}_{m}^{(BG2)}$ in memory, and instantaneously checks sub-layer scheduling sequences $\mathcal{S}_{m'}^{(BG1)}$ and $\mathcal{S}_{m'}^{(BG2)}$ for a given $m'$.

According to another embodiment of the present disclosure, the layered decoder records or stores the sub-layer scheduling sequences $\mathcal{S}_{m'}^{(BG1)}$ and $\mathcal{S}_{m'}^{(BG2)}$ in the memory for all possible occurrences of $m'$, and reads and checks the corresponding sub-layer scheduling sequences for the given $m'$.

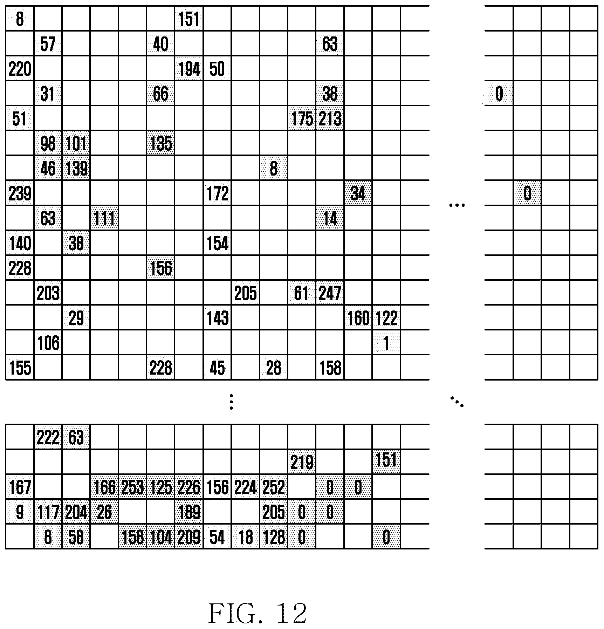

According to another embodiment of the present disclosure, the layered decoder may perform decoding based on a transformed parity check matrix, which is permuted (or interleaved) by rows or row blocks of an entire parity check matrix H being used, based on the entire layer scheduling sequence $\mathcal{S}_{m}^{(BG1)}$ or $\mathcal{S}_{m}^{(BG2)}$. FIG. 12 is a diagram illustrating a transformed parity check matrix obtained by permuting the parity check matrix defined based on BG2 of FIG. 11 in an order of the $\mathcal{S}_{m}^{(BG2)}$. As described above, the transformed parity check matrix, which permutes an order of rows or row blocks will be written as $\overline{H}$. Even if the order of the rows or row blocks is permuted like this, since there is no change in

the establishment of $\overline{H}x = 0$, it should be noted that the use of the transformed parity check matrix does not change the fundamental problem of estimating a codeword by decoding based on the codeword LLR sequence.

The layered decoder of the LDPC code may perform decoding based on the transformed parity check matrix in which the order of rows or row blocks is permuted as illustrated in FIG. 12. In the case that puncturing occurs and the sub parity check matrix is used, the row or the row block in the transformed parity check matrix $\overline{H}$ corresponding to the row or the row block punctured in the original parity check matrix H may be deactivated or skipped in the operation. That is, the layered decoder may include a process of checking validity of each layer or each row or row block in a process of performing decoding based on the transformed parity check matrix $\overline{H}$.

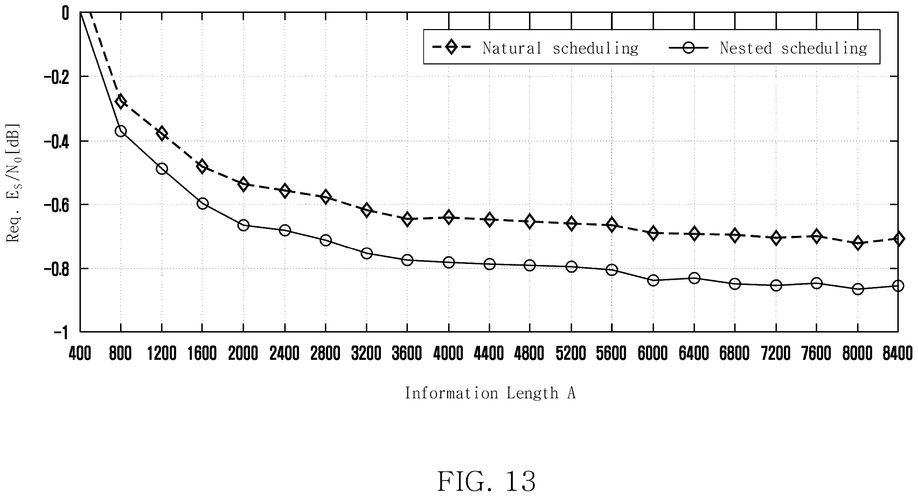

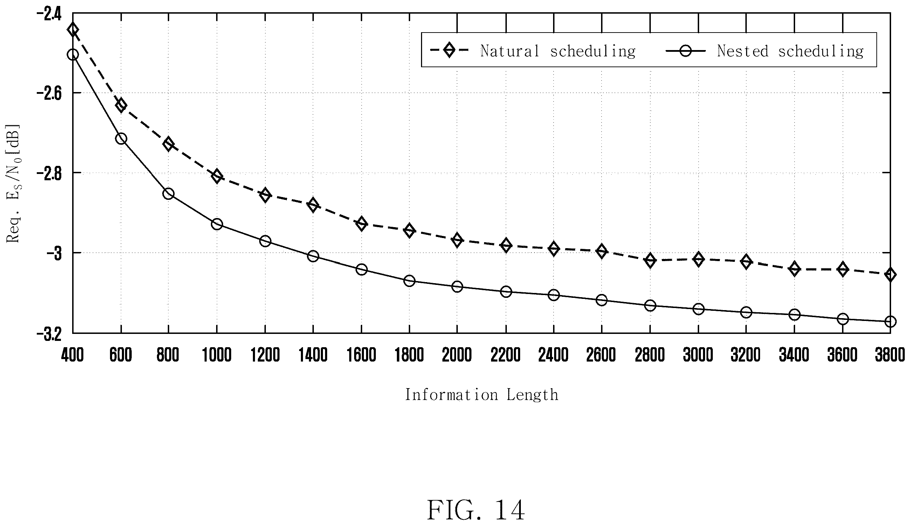

FIGS. 13 and 14 illustrate an experimental performance of layered decoding performed by a receiver when transmitting a codeword generated based on parity check matrices made of BG1 and BG2 in the 3GPP NR system, respectively. In this experiment, an additive white Gaussian noise (AWGN) channel is considered, and QPSK is considered as a modulation technique. In this drawing, an x-axis indicates a size $A$ of a code block that transmits. In this drawing, a y-axis indicates a signal-to-noise ratio (SNR), which is required to achieve a block error rate (BLER) of 1% when the layered decoding is performed, in decibels (dB). $E_s$ using $E_s/N_0$ as a metric of signal-to-noise ratio is average energy of a modulation symbol, and $N_0$ is spectral density of noise. In this drawing, the smaller the y-axis value, the better the performance. This is because it shows that the same block error rate of 1% may be achieved even if the signal is transmitted with less power for the same code block size.

A LDPC code decoding method performed by the receiver in a communication system according to an embodiment of the present disclosure may include a step of receiving a signal corresponding to a transport block and a code block, a step of checking a base matrix or/and a parity-check matrix (PCM) necessary for decoding the transport block or the code block, and a step of performing layered decoding of a low-density parity-check (LDPC) code using the signal for the transport block and the code block or soft probabilistic information and the base matrix or/and the parity check matrix, and the step of performing layered decoding of the LDPC code may perform decoding using at least a partial area of the parity check matrix according to a predetermined layer scheduling rule.

A decoding method of the receiver according to an embodiment of the present disclosure may include a step of receiving a signal corresponding to an input bit transmitted from a transmitter, a step of checking the sign parameter based on the signal, a step of checking the transport block or the code block based on the sign parameter, a step of checking or determining the base matrix or/and parity check matrix to be used for decoding the transport block or the code block, and a step of performing layered decoding based on the base matrix or/and the parity check matrix. According to the present disclosure, the layered decoding may be performed sequentially based on a layer scheduling sequence determined to improve a performance and a convergence speed while minimizing the number (e.g., the number of pipelines and threads and the like, processed by hardware) of layer processing necessary for decoding, by maximizing the number of layers processing simultaneously in each time step based on the characteristics of the base matrix or/and the parity check matrix.

In particular, the layered decoding method of the present disclosure for the LDPC code of the 3GPP NR system that is a 5G communication standard, is performed sequentially based on all or a portion of a layer scheduling sequence described below according to a type of a base graph (BG) that defines the parity check matrix being used, and layers of an index included in the same parentheses may be processed sequentially or simultaneously. Therefore, the present disclosure may further include a process of checking a layer scheduling sequence corresponding to the base matrix or the parity check matrix to perform the layered decoding, or a process of determining an order of layers for the layered decoding based on the layer scheduling sequence.

For example, a layer scheduling sequence for BG1 may be determined as follows.

[(42, 43), (37, 36), (27, 26), (40, 41), (45, 44), (28, 29), (30, 31), (22, 23), (32, 33), (34, 35), (38, 39), (25, 24), 13, (17, 18), (16, 14), (10, 6), (20, 21), 4, 19, 7, 12, 15, 5, 11, 9, 8, 3, 1, 0, 2].

For example, a layer scheduling sequence for BG2 may be determined as follows.

[(27, 35), (18, 38), (15, 28), (24, 39), (12, 36), (25, 9, 26), (31, 6), (33, 32, 14), (29, 7), (34, 41), (20, 21, 30), (11, 17), 8, (40, 23, 16), 19, 4, 13, 10, 5, 2, (22, 37, 1), 0, 3].

The receiver in the communication system according to an embodiment of the present disclosure receives a signal corresponding to the transport block and the code block, checks the parity-check matrix (PCM) necessary for decoding the code block, and performs layered decoding of a low-density parity-check (LDPC) code using the signal for the code block or soft probabilistic information and the parity check matrix, and a portion performing layered decoding of the LDPC code may include a control unit that controls to decode using at least a partial area of the parity check matrix according to a predetermined layer scheduling rule.

The receiver according to an embodiment of the present disclosure may be configured of a portion that receives a signal corresponding to the input bit transmitted from the transmitter, a portion that checks a code parameter based on the signal, a portion that checks the code block based on the code parameter, a portion that checks or determines the parity check matrix to be used for decoding the code block, and a decoder that performs layered decoding based on the parity check matrix, and the layered decoder may be controlled to be performed sequentially based on the layer scheduling sequence determined to improve the performance and the convergence speed while minimizing the number (e.g., the number of pipelines and threads and the like, processed by hardware) of layer processing necessary for decoding, by maximizing the number of layers processing simultaneously in each time step based on the characteristics of the parity check matrix.

In particular, the layered decoder of the present disclosure for the LDPC code of the 3GPP NR system that is the 5G communication standard may include the control unit that controls to perform decoding based on at least a portion of the layer scheduling sequence described below according to the type of base graph (BG) that defines the parity check matrix being used, and may process the layers of the index included in the same parentheses sequentially or simultaneously. Therefore, the present disclosure may further include a process of checking a layer scheduling sequence corresponding to the base matrix or the parity check matrix to perform the layered decoding or a process of determining an order of layers for the layered decoding based on the layer scheduling sequence.

For example, the layer scheduling sequence for BG1 may be determined as follows.

[(42, 43), (37, 36), (27, 26), (40, 41), (45, 44), (28, 29), (30, 31), (22, 23), (32, 33), (34, 35), (38, 39), (25, 24), 13, (17, 18), (16, 14), (10, 6), (20, 21), 4, 19, 7, 12, 15, 5, 11, 9, 8, 3, 1, 0, 2].

For example, the layer scheduling sequence for BG2 may be determined as follows.

[(27, 35), (18, 38), (15, 28), (24, 39), (12, 36), (25, 9, 26), (31, 6), (33, 32, 14), (29, 7), (34, 41), (20, 21, 30), (11, 17), 8, (40, 23, 16), 19, 4, 13, 10, 5, 2, (22, 37, 1), 0, 3].

Scheduling FIG. 13 is a diagram respectively illustrating block error rates of layered decoding in a natural order and layered decoding that is layer scheduled by an embodiment of the present disclosure, with respect to a parity check matrix defined based on BG1. As illustrated in the drawings, layered decoding configured by an embodiment of the present disclosure indicates better performance than the natural order.

Scheduling FIG. 14 is a diagram respectively illustrating block error rates of layered decoding in a natural order and layered decoding that is layer scheduled by an embodiment of the present disclosure, with respect to a parity check matrix defined based on BG2. As illustrated in the drawings, layered decoding configured by an embodiment of the present disclosure indicates better performance than natural order.

Methods according to the embodiments described in the claims or specification of the present disclosure may be implemented in a form of hardware, software, or a combination of hardware and software.

When implemented as software, a computer-readable storage medium or a computer program product for storing one or more programs (software modules) may be provided. The one or more programs stored in the computer-readable storage medium or the computer program product are configured for execution by one or more processors in an electronic device. The one or more programs include instructions that cause the electronic device to execute the methods according to the embodiments described in the claims or specification of the present disclosure.

These programs (software modules and software) may be stored in random access memory, non-volatile memory including flash memory, Read Only Memory (ROM), Electrically Erasable Programmable Read Only Memory (EEPROM), a magnetic disc storage device, Compact Disc-ROM (CD-ROM), Digital Versatile Discs (DVDs) or another type of an optical storage device, and a magnetic cassette. Alternatively, they may be stored in memory composed of some or all combinations thereof. Also, each of the composed memories may be included in plural.

Additionally, the programs may be stored in an attachable storage device that is accessible via a communication network such as the Internet, an intranet, a local area network (LAN), a wide LAN (WLAN), or a combination thereof. This storage device may connect to a device performing an embodiment of the present disclosure through an external port. In addition, a separate storage device on the communication network may connect to the device performing the embodiment of the present disclosure.

In the above-described specific embodiments of the present disclosure, components included in the present disclosure have been expressed singular or plural according to the presented specific embodiment. However, singular or plural expressions are selected appropriately for the situation presented for convenience of explanation, and the present disclosure is not limited to singular or plural components, and even if a component is expressed in plural, it may be composed in singular, or even if a component is expressed in singular, it may be composed in plural.

Meanwhile, the embodiments of the present disclosure disclosed in this specification and drawings are merely specific examples to easily explain the technical content of the present disclosure and to help understand the present disclosure, and are not intended to limit the scope of the present disclosure. In other words, it is obvious to those skilled in the art that other modified examples based on the technical idea of the present disclosure may be implemented. In addition, each of the above embodiments may be operated in combination with each other as necessary. For example, a base station and a terminal may be operated by combining parts of an embodiment and another embodiment of the present invention. The embodiments of the present disclosure are applicable to another communication system, and other modified embodiments based on the technical idea of the embodiment will also be possible. For example, the embodiments may be applied to an LTE system, a 5G or an NR system, and the like.

**Claims**

1. A decoding method performed by a receiver of a communication system comprising:

   receiving a signal transmitted from a transmitter;
   identifying a parity check matrix for decoding the signal;
   identifying a first layer scheduling sequence corresponding to the parity check matrix; and
   performing layered decoding based on at least a portion of the parity check matrix and at least a portion of the first layer scheduling sequence,
   wherein each index included in the first layer scheduling sequence corresponds to a row block of the parity check matrix,
   wherein the first layer scheduling sequence corresponds to a plurality of layers of which each layer is configured with one or more row block of the parity check matrix,
   wherein the plurality of layers corresponding to the first layer scheduling sequence respectively correspond to one or more index included in the first layer scheduling sequence, and
   wherein at least one layer among the plurality of layers corresponding to the first layer scheduling sequence is configured with a plurality of orthogonal row blocks in the parity check matrix.

2. The method of claim 1,
   wherein an order of layers for the layered decoding is determined, in case that the layered decoding is performed based on a sub parity check matrix of the parity check matrix, based on a second layer scheduling sequence corresponding to the sub parity check matrix.

3. The method of claim 2,
   wherein the second layer scheduling sequence corresponding to the sub parity check matrix is a sub layer scheduling sequence of the first layer scheduling sequence corresponding to the parity check matrix.

4. The method of claim 2,
   wherein the second layer scheduling sequence corresponding to the sub parity check matrix is determined by excluding, from the first layer scheduling sequence corresponding to the parity check matrix, an index greater than or equal to a number (m') of rows of the sub parity check matrix.

5. The method of claim 1,
   wherein a layer processed first in the first layer scheduling sequence is configured with at least two orthogonal row blocks in the parity check matrix.

6. The method of claim 5,

   in case that the parity check matrix is defined based on a first matrix,
   wherein the layer processed first in the first layer scheduling sequence is configured with row blocks corresponding to indexes 42 and 43 in the parity check matrix defined based on the first matrix.

7. The method of claim 5,

   in case that the parity check matrix is defined based on a second matrix,
   wherein the layer processed first in the first layer scheduling sequence is configured with row blocks corresponding to indexes 27 and 35 in the parity check matrix defined based on the second matrix.

8. The method of claim 1,

   in case that the parity check matrix is defined based on the first matrix,
   wherein a first layer scheduling sequence corresponding to the parity check matrix is {(42, 43), (37, 36), (27, 26), (40, 41), (45, 44), (28, 29), (30, 31), (22, 23), (32, 33), (34, 35), (38, 39), (25, 24), 13, (17, 18), (16, 14), (10, 6), (20, 21), 4, 19, 7, 12, 15, 5, 11, 9, 8, 3, 1, 0, 2}.

9. The method of claim 1,

   in case that the parity check matrix is defined based on the second matrix,

wherein a first layer scheduling sequence corresponding to the parity check matrix is {(27, 35), (18, 38), (15, 28), (24, 39), (12, 36), (25, 9, 26), (31, 6), (33, 32, 14), (29, 7), (34, 41), (20, 21, 30), (11, 17), 8, (40, 23, 16), 19, 4, 13, 10, 5, 2, (22, 37, 1), 0, 3}.

10. The method of claim 1,
wherein a layer corresponding to a plurality of indexes from among the plurality of layers corresponding to the first layer scheduling sequence is configured with a plurality of orthogonal row blocks corresponding to the plurality of indexes.

11. The method of claim 10,
wherein each of the row blocks configuring a layer corresponding to the plurality of indexes is processed in parallel.

12. A receiver performing decoding in a communication system, comprising:

a transceiver; and
a control unit configured to:

receive a signal transmitted from a transmitter;
identify a parity check matrix for decoding the signal;
identify a first layer scheduling sequence corresponding to the parity check matrix; and
perform layered decoding based on at least a portion of the parity check matrix and at least a portion of the first layer scheduling sequence,
wherein each index included in the first layer scheduling sequence corresponds to a row block of the parity check matrix,
wherein the first layer scheduling sequence corresponds to a plurality of layers of which each layer is configured with one or more row block of the parity check matrix,
wherein the plurality of layers corresponding to the first layer scheduling sequence respectively correspond to one or more index included in the first layer scheduling sequence, and
wherein at least one layer among the plurality of layers corresponding to the first layer scheduling sequence is configured with a plurality of orthogonal row blocks in the parity check matrix.

13. The receiver of claim 12,
wherein an order of layers for the layered decoding is determined, in case that the layered decoding is performed based on a sub parity check matrix of the parity check matrix, based on a second layer scheduling sequence corresponding to the sub parity check matrix.

14. The receiver of claim 13,
wherein the second layer scheduling sequence corresponding to the sub parity check matrix is a sub layer scheduling sequence of the first layer scheduling sequence corresponding to the parity check matrix.

15. The receiver of claim 13,
wherein the second layer scheduling sequence corresponding to the sub parity check matrix is determined by excluding, from the first layer scheduling sequence corresponding to the parity check matrix, an index greater than or equal to a number (m') of rows of the sub parity check matrix.

| TRANSMITTING END (110) | → | RECEIVING END (120) |

FIG. 1

RECEIVING END
(120)

CONTROL UNIT
(230)

COMMUNICATION
UNIT (210)

STORAGE UNIT
(220)

FIG. 2

$$H = \begin{bmatrix} 1 & 1 & 1 & 1 & 0 & 1 & 1 & 0 & 0 & 0 \\ 0 & 0 & 1 & 1 & 1 & 1 & 1 & 1 & 0 & 0 \\ 0 & 1 & 0 & 1 & 0 & 1 & 0 & 1 & 1 & 1 \\ 1 & 0 & 1 & 0 & 1 & 0 & 0 & 1 & 1 & 1 \\ 1 & 1 & 0 & 0 & 1 & 0 & 1 & 0 & 1 & 1 \end{bmatrix}$$

FIG. 3

FIG. 4

[500]

**TRANSMISSION DEVICE**

Segmentation [510] → Outer Coding (CRC) [520] → Zero Filling [530] → LDPC Encoding [540] → Rate Matching [550] → Interleaving [560] → Concatenation [570] → Modulation [580]

FIG. 5

RECEPTION DEVICE
[600]

| Demodulation [610] | Inverse Concatenation [620] | Deinterleaving [630] | Rate Dematching [640] | HARQ Soft-Combining [650] | LDPC Decoding [660] | Zero Removal [670] | Outer Decoding [680] | Inverse Segmentation [690] |

FIG. 6

FIG. 7

FIG. 8

FIG. 9

FIG. 10

EP 4 513 766 A1

[1100]

[1110] → | 9 | 117 | 204 | 26 | | | 189 | | | 205 | 0 | 0 | | | | | | |
[1120] → | 167 | | | 166 | 253 | 125 | 226 | 156 | 224 | 252 | | 0 | 0 | | | | | |

| 81 | 114 | | 44 | 52 | | | | 240 | | 1 | | 0 | 0 | | | | |
| | 8 | 58 | | 158 | 104 | 209 | 54 | 18 | 128 | 0 | | | 0 | | | | |
| 179 | 214 | | | | | | | | | 71 | | | 0 | | | | |
| 231 | 41 | | | 194 | | 159 | | | | 103 | | | | | | | |
| 155 | | | | 228 | | 45 | | 28 | | 158 | | | | | | | |
| | 129 | | | 147 | | 140 | | | | 3 | | 116 | | | | | |
| 149 | 94 | | | | | | | | | | 230 | | | | | | |
| | 203 | | | | | | 205 | | 61 | 247 | | | | | | | |
| 11 | 185 | | | | | 0 | 117 | | | | | | | | | | |

[1130] → | 11 | | | | | | 236 | | 210 | | | | 56 | | | | | |
| | 63 | | 111 | | | | | | | 14 | | | | | | | |

| 83 | 2 | | | | | | 38 | | | | | 222 | | | | | |
| | 115 | | | | 145 | | | | | 3 | | 232 | | | | | |

⋮

| 239 | | | | | | 172 | | | | 34 | | | | | 0 | | |
| | 0 | | | | | | | 75 | | | 120 | | | | | 0 | |
| | 129 | | | 229 | | | | | | 118 | | | | | | | 0 |

FIG. 11

FIG. 12

FIG. 13

FIG. 14

## INTERNATIONAL SEARCH REPORT

| International application No. |
|---|
| **PCT/KR2023/004828** |

**A.    CLASSIFICATION OF SUBJECT MATTER**

**H03M 13/11**(2006.01)i; **H03M 13/00**(2006.01)i

According to International Patent Classification (IPC) or to both national classification and IPC

**B.    FIELDS SEARCHED**

Minimum documentation searched (classification system followed by classification symbols)

H03M 13/11(2006.01); H03M 13/00(2006.01); H03M 13/37(2006.01); H04L 1/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 패리티 검사 행렬(parity check matrix), 레이어 스케줄링 시퀀스(layer scheduling sequence), 레이어드 복호(layered decoding), 행 블록(row block), 직교(orthogonal), sub parity check matrix, sub layer scheduling sequence, 병렬(parallel)

**C.    DOCUMENTS CONSIDERED TO BE RELEVANT**

| Category* | Citation of document, with indication, where appropriate, of the relevant passages | Relevant to claim No. |
|---|---|---|
| X | KR 10-2021-0030848 A (SAMSUNG ELECTRONICS CO., LTD.) 18 March 2021 (2021-03-18)<br>    See paragraphs [0013]-[0017] and [0335]-[0636]; and claims 1-6. | 1-3,5,10-14 |
| A | | 4,6-9,15 |
| A | US 11265014 B2 (HUAWEI TECHNOLOGIES CO., LTD.) 01 March 2022 (2022-03-01)<br>    See column 6, line 18 – column 14, line 51; and figures 1-12. | 1-15 |
| A | US 10972217 B2 (QUALCOMM INCORPORATED) 06 April 2021 (2021-04-06)<br>    See column 14, line 21 – column 29, line 43; and figures 2-14. | 1-15 |
| A | US 10177786 B2 (TIDAL SYSTEMS, INC.) 08 January 2019 (2019-01-08)<br>    See column 5, line 34 – column 10, line 39. | 1-15 |
| A | US 2022-0085828 A1 (CODELUCIDA, INC.) 17 March 2022 (2022-03-17)<br>    See paragraphs [0042]-[0097]. | 1-15 |

☐ Further documents are listed in the continuation of Box C.        ☑ See patent family annex.

| | |
|---|---|
| *    Special categories of cited documents:<br>"A"   document defining the general state of the art which is not considered to be of particular relevance<br>"D"   document cited by the applicant in the international application<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
| **27 June 2023** | **28 June 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

| INTERNATIONAL SEARCH REPORT | | | | International application No. | |
|---|---|---|---|---|---|
| **Information on patent family members** | | | | **PCT/KR2023/004828** | |

| Patent document cited in search report | | | Publication date (day/month/year) | Patent family member(s) | | | Publication date (day/month/year) |
|---|---|---|---|---|---|---|---|
| KR | 10-2021-0030848 | A | 18 March 2021 | CN | 114270710 | A | 01 April 2022 |
| | | | | EP | 3963723 | A1 | 09 March 2022 |
| | | | | US | 11177830 | B2 | 16 November 2021 |
| | | | | US | 2021-0075442 | A1 | 11 March 2021 |
| | | | | US | 2022-0077874 | A1 | 10 March 2022 |
| | | | | WO | 2021-049888 | A1 | 18 March 2021 |
| US | 11265014 | B2 | 01 March 2022 | AU | 2017-355038 | A1 | 16 May 2019 |
| | | | | AU | 2017-355038 | B2 | 03 September 2020 |
| | | | | BR | 112019009090 | A2 | 12 November 2019 |
| | | | | CN | 109891753 | A | 14 June 2019 |
| | | | | CN | 110572163 | A | 13 December 2019 |
| | | | | CN | 110572163 | B | 08 September 2020 |
| | | | | EP | 3533146 | A1 | 04 September 2019 |
| | | | | JP | 2019-536341 | A | 12 December 2019 |
| | | | | JP | 7152394 | B2 | 12 October 2022 |
| | | | | KR | 10-2019-0065420 | A | 11 June 2019 |
| | | | | KR | 10-2155539 | B1 | 14 September 2020 |
| | | | | RU | 2019116852 | A | 03 December 2020 |
| | | | | RU | 2739465 | C2 | 24 December 2020 |
| | | | | US | 10567002 | B2 | 18 February 2020 |
| | | | | US | 2019-0260390 | A1 | 22 August 2019 |
| | | | | US | 2020-0162107 | A1 | 21 May 2020 |
| | | | | WO | 2018-082290 | A1 | 11 May 2018 |
| | | | | WO | 2018-084735 | A1 | 11 May 2018 |
| US | 10972217 | B2 | 06 April 2021 | CN | 112204889 | A | 08 January 2021 |
| | | | | EP | 3776870 | A1 | 17 February 2021 |
| | | | | US | 2019-0305882 | A1 | 03 October 2019 |
| | | | | WO | 2019-191398 | A1 | 03 October 2019 |
| US | 10177786 | B2 | 08 January 2019 | US | 2017-0026055 | A1 | 26 January 2017 |
| | | | | US | 2017-0331495 | A1 | 16 November 2017 |
| | | | | US | 9755666 | B2 | 05 September 2017 |
| US | 2022-0085828 | A1 | 17 March 2022 | CN | 113517895 | A | 19 October 2021 |
| | | | | EP | 3893399 | A1 | 13 October 2021 |
| | | | | TW | 202203238 | A | 16 January 2022 |
| | | | | US | 11496155 | B2 | 08 November 2022 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **S. MYUNG** ; **K. YANG** ; **Y. KIM**. Lifting methods for quasi-cyclic LDPC codes. *IEEEE Commun. Lett*, June 2006, vol. 10, 489-491